(19) Europäisches Patentamt
European Patent Office
Office européen des brevets

(11) **EP 4 572 246 A1**

(12) **EUROPEAN PATENT APPLICATION**
published in accordance with Art. 153(4) EPC

(43) Date of publication:
**18.06.2025 Bulletin 2025/25**

(21) Application number: **23858923.8**

(22) Date of filing: **30.06.2023**

(51) International Patent Classification (IPC):
**H04L 25/49** (2006.01)   **H04W 24/02** (2009.01)

(52) Cooperative Patent Classification (CPC):
**H03F 1/32; H04L 25/49; H04W 24/02**

(86) International application number:
**PCT/CN2023/105346**

(87) International publication number:
**WO 2024/045885 (07.03.2024 Gazette 2024/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.08.2022 CN 202211053928**

(71) Applicant: **Huawei Technologies Co., Ltd.
Shenzhen, Guangdong 518129 (CN)**

(72) Inventors:
• **PENG, Zhongchong
Shenzhen, Guangdong 518129 (CN)**
• **LIU, Fengwei
Shenzhen, Guangdong 518129 (CN)**
• **QIAO, Hao
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **INFORMATION MEASUREMENT METHOD AND APPARATUS**

(57) This application provides an information measurement method and an apparatus, to improve accuracy of a determined DPD coefficient corresponding to a digital channel. The method includes: A network device sends first configuration information and second configuration information to a terminal device, where the first configuration information indicates configuration information of Q reference signals, and the second configuration information indicates model parameters of equivalent power amplifiers connected to Q digital channels of the network device. The terminal device receives the Q reference signals sent by the network device, to obtain a receiving signal. The terminal device determines a model coefficient of an equivalent power amplifier based on the receiving signal, the configuration information of the Q reference signals, and the model parameters of the equivalent power amplifiers. The terminal device sends the model coefficient of the equivalent power amplifier to the network device. The network device determines, based on the model coefficient, a digital predistortion coefficient corresponding to the digital channel.

FIG. 9

## Description

This application claims priority to Chinese Patent Application No. 202211053928.7, filed with the China National Intellectual Property Administration on August 31, 2022 and entitled "INFORMATION MEASUREMENT METHOD AND APPARATUS", which is incorporated herein by reference in its entirety.

## TECHNICAL FIELD

This application relates to the communication field, and more specifically, to an information measurement method and an apparatus.

## BACKGROUND

A power amplifier (power amplifier, PA) can amplify a low-power signal generated by a network device or a terminal device to a power level capable of long-range transmission. A PA is a core component of a wireless communication device. During power amplification, the PA may introduce nonlinear distortion, leading to deterioration in a performance indicator of an output signal. For example, the nonlinear distortion caused by the PA may lead to performance deterioration in an error vector magnitude (error vector magnitude, EVM) and an adjacent channel leakage power ratio (adjacent channel leakage power ratio, ACLR) of the output signal.

A digital predistortion (digital predistortion, DPD) technique is an effective means of improving linearity of an output signal of a PA, and has a basic principle of performing digital preprocessing on an original signal of a digital channel before the PA performs power amplification on the original signal, to improve the linearity of the output signal of the PA. Theoretically, a function corresponding to DPD is an inverse function of a response function of the PA.

In a frequency band such as millimeter waves, a network device (a transmitting device) may use more physical antennas to obtain an array gain, to counteract a propagation loss of a high-frequency signal. For example, there may be hundreds or thousands of antenna elements included in a network device with a frequency band of 26 GHz to 28 GHz. To avoid excessively high costs and power consumption caused by a large-scale array, the network device may use a hybrid beamforming (hybrid beamforming, HBF) architecture. In the HBF architecture, a quantity of digital channels is far less than a quantity of physical antennas. In new radio (new radio, NR), the HBF architecture may be usually divided into two hardware design structures. One is a partially connected structure (partially connected structure, PCS), where each digital channel is connected to all physical antennas of only one subarray. The other is a fully connected structure (fully connected structure, FCS), where each digital channel is connected to all physical antennas of all subarrays. Whether the HBF architecture is the HBF PCS architecture or the HBF FCS architecture, digital predistortion needs to be implemented at the digital channel.

Currently, for the HBF PCS architecture, the network device may add a DPD module to each digital channel based on an original signal of each digital channel and feedback signals of all physical antennas, to correct nonlinear distortion of a signal amplified by a PA. Specifically, the network device reconstructs a receiving signal of a terminal device using an estimated channel response coefficient and an output signal that is of the physical antenna and that is obtained through wired feedback, and finally determines, based on the original signal of the digital channel and the receiving signal of the terminal device, a DPD coefficient corresponding to the digital channel. In this process, the channel response coefficient estimated by the network device may have a large error, and the reconstructed receiving signal of the terminal device deviates from an actual receiving signal of the terminal device. As a result, the determined DPD coefficient has low accuracy. In addition, when there are a large quantity of physical antennas, hardware costs for wired feedback are high, leading to high costs in determining the DPD coefficient. For the HBF FCS architecture, the network device compensates for a nonlinear effect of all PAs connected to a single digital channel, to ensure signal quality of a receiving signal of a remote device. However, in an actual NR system, in addition to a partially connected structure, the HBF architecture further includes a fully connected structure, and impact of intermodulation interference between different digital channels needs to be taken into account during correction of nonlinear distortion of the PA.

## SUMMARY

This application provides an information measurement method and an apparatus, to improve accuracy of a determined DPD coefficient corresponding to a digital channel or improve flexibility of determining the DPD coefficient corresponding to the digital channel.

According to a first aspect, an information measurement method is provided. The method may be performed by a chip or a chip system on a terminal device side. The method includes: A terminal device receives first configuration information sent by a network device, where the first configuration information indicates configuration information of Q reference signals, and Q is an integer greater than 1. The terminal device receives second configuration information sent by the network device, where the second configuration information indicates model parameters of equivalent power amplifiers connected to Q digital channels of the network device. The terminal device receives the Q reference signals sent by the network device, to obtain a receiving signal. The terminal device determines a model coefficient of an equivalent power amplifier based on the receiving signal, the configuration information of the Q reference signals, and the model parameters of the equivalent power amplifiers, where the equivalent power amplifier is an equivalent power amplifier of power amplifiers connected to the digital channel corresponding to the receiving signal. The terminal device sends the model coefficient of the equivalent power amplifier to the network device.

According to the foregoing technical solution, the network device sends the first configuration information and the second configuration information to the terminal devices; the terminal devices may reconstruct the Q reference signals of the Q digital channels of the network device based on the first configuration information; the terminal devices may determine and report the model coefficients of the equivalent power amplifiers of the Q digital channels of the network device based on the Q reference signals and the model parameters of the equivalent power amplifiers that are indicated by the second configuration information; and the network device may determine, based on the model coefficients of the equivalent power amplifiers connected to the Q digital channels, the digital predistortion coefficients corresponding to the Q digital channels. Compared with a solution in which a receiving signal of a terminal device is determined based on an output signal of each physical antenna and a channel response coefficient between each physical antenna and the terminal device, and then a digital predistortion coefficient corresponding to a digital channel is determined based on the receiving signal of the terminal device, this embodiment of this application can obviate the need to obtain an output signal of each physical antenna through wired feedback, thereby reducing costs. In addition, this embodiment of this application obviates the need to estimate the channel response coefficient between each physical antenna and the terminal device, thereby improving accuracy of the determined DPD coefficient corresponding to the digital channel.

With reference to the first aspect, in some implementations of the first aspect, that the terminal device determines a model coefficient of an equivalent power amplifier based on the receiving signal, the configuration information of the Q reference signals, and the model parameters of the equivalent power amplifiers includes: The terminal device determines the Q reference signals based on the configuration information of the Q reference signals. The terminal device determines the model coefficient of the equivalent power amplifier based on the receiving signal, the Q reference signals, and the model parameters of the equivalent power amplifiers.

With reference to the first aspect, in some implementations of the first aspect, the configuration information of the Q reference signals includes one or more of the following: type information of the Q reference signals, sequence information of the Q reference signals, time-frequency resource information of the Q reference signals, or antenna port information for sending the Q reference signals, where the sequence information of the Q reference signals is different, and the time-frequency resource information is in a one-to-one correspondence with the antenna port information. The configuration information of the reference signals may be used by Q terminal devices to determine (reconstruct) the reference signals of the Q digital channels.

With reference to the first aspect, in some implementations of the first aspect, the model parameter includes at least one of a nonlinear order, a memory depth, a cross-term length, or a model type.

With reference to the first aspect, in some implementations of the first aspect, the first configuration information further indicates bandwidth information of the Q reference signals. Based on the bandwidth information of the Q reference signals, the terminal device can fully obtain out-of-band information of signals obtained from the Q reference signals amplified by the power amplifiers, or accurately set a width of a band-pass filter, to implement a band-limited nonlinear model estimation algorithm, thereby improving accuracy of the determined model coefficient of the equivalent power amplifier.

With reference to the first aspect, in some implementations of the first aspect, the Q digital channels are connected to respective corresponding power amplifiers. The method may be applicable to an FCS architecture.

According to a second aspect, an information measurement method is provided. The method may be performed by a chip or a chip system on a network device side. The method includes: The network device sends first configuration information to Q terminal devices, where the first configuration information indicates configuration information of Q reference signals, and Q is an integer greater than 1. The network device sends second configuration information to the Q terminal devices, where the second configuration information indicates model parameters of equivalent power amplifiers connected to Q digital channels of the network device. The network device sends the Q reference signals to the Q terminal devices through P physical antennas, where the power amplifiers are connected to the physical antennas in a one-to-one correspondence, and P is an integer greater than or equal to Q. The network device receives model coefficients of Q equivalent power amplifiers sent by the Q terminal devices, where the equivalent power amplifiers are equivalent power amplifiers of power amplifiers connected to the digital channels corresponding to receiving signals of the terminal devices, and the receiving signals are the Q reference signals received by the terminal devices.

The method provided in the second aspect is a method on a network device side corresponding to the first aspect. For its beneficial effects, directly refer to the first aspect.

With reference to the second aspect, in some implementations of the second aspect, the configuration information of the Q reference signals includes one or more of the following: type information of the Q reference signals, sequence information of the Q reference signals, time-frequency resource information of the Q reference signals, or antenna port information for sending the Q reference signals, where the sequence information of the Q reference signals is different, and the time-frequency resource information is in a one-to-one correspondence with the antenna port information. The configuration information of the reference signals may be used by the Q terminal devices to determine (reconstruct) the reference signals of the Q digital channels.

With reference to the second aspect, in some implementations of the second aspect, the model parameter includes at least one of a nonlinear order, a memory depth, a cross-term length, or a model type.

With reference to the second aspect, in some implementations of the second aspect, the first configuration information further indicates bandwidth information of the Q reference signals. Based on the bandwidth information of the Q reference signals, the terminal device can fully obtain out-of-band information of signals obtained from the Q reference signals amplified by the power amplifiers, or accurately set a width of a band-pass filter, to implement a band-limited nonlinear model estimation algorithm, thereby improving accuracy of the model coefficient of the equivalent power amplifier that is determined by the terminal device.

With reference to the second aspect, in some implementations of the second aspect, the method further includes: The network device determines, based on the model coefficients of the Q equivalent power amplifiers and the Q reference signals, digital predistortion coefficients respectively corresponding to the Q digital channels.

With reference to the second aspect, in some implementations of the second aspect, that the network device determines, based on the model coefficients of the Q equivalent power amplifiers and the Q reference signals, digital predistortion coefficients respectively corresponding to the Q digital channels includes: The network device determines Q receiving signals of the Q terminal devices based on the model coefficients of the Q equivalent power amplifiers, the Q reference signals, and the model parameters of the equivalent power amplifiers, where the receiving signals are in a one-to-one correspondence with the terminal devices. The network device determines, based on the Q receiving signals and a $q^{th}$ reference signal in the Q reference signals, a digital predistortion coefficient corresponding to a $q^{th}$ digital channel in the Q digital channels, where the $q^{th}$ digital channel is a digital channel corresponding to the $q^{th}$ reference signal, and $1 \leq q \leq Q$.

With reference to the second aspect, in some implementations of the second aspect, the Q digital channels are connected to respective corresponding power amplifiers. The method may be applicable to an FCS architecture.

According to a third aspect, an information measurement method is provided. The method may be performed by a chip or a chip system on a terminal device side. The method includes: A terminal device receives first configuration information sent by a network device, where the first configuration information indicates configuration information of a reference signal. The terminal device receives second configuration information sent by the network device, where the second configuration information indicates a model parameter of an equivalent power amplifier connected to a digital channel of the network device. The terminal device receives the reference signal sent by the network device, to obtain a receiving signal. The terminal device determines a model coefficient of an equivalent power amplifier based on the receiving signal, the configuration information of the reference signal, and the model parameter of the equivalent power amplifier, where the equivalent power amplifier is an equivalent power amplifier of power amplifiers connected to the digital channel. The terminal device sends the model coefficient of the equivalent power amplifier to the network device.

According to the foregoing technical solution, in the technical solution provided in this embodiment of this application, the network device sends the first configuration information and the second configuration information to the terminal device; the terminal device may reconstruct the reference signal of the digital channel of the network device based on the first configuration information; the terminal device may determine and report the model coefficient of the equivalent power amplifier connected to the digital channel based on the reference signal and the model parameter of the equivalent power amplifier of the digital channel that is indicated by the second configuration information; and the network device may determine, based on the model coefficient of the equivalent power amplifier of the digital channel, the digital predistortion coefficient corresponding to the digital channel by using a direct learning structure or an indirect learning structure. Compared with a solution in which a remote device measures and directly feeds back a **DPD** coefficient, this embodiment of this application allows the network device to flexibly determine, based on a model coefficient of an equivalent power amplifier of a digital channel that is fed back by the remote device, a digital predistortion coefficient corresponding to the digital channel, and the terminal device is not able to know an algorithm used by the network device to determine the **DPD** coefficient.

With reference to the third aspect, in some implementations of the third aspect, that the terminal device determines a model coefficient of an equivalent power amplifier based on the receiving signal, the configuration information of the reference signal, and the model parameter of the equivalent power amplifier includes: The terminal device determines the reference signal based on the configuration information of the reference signal. The terminal device determines the model coefficient of the equivalent power amplifier based on the receiving signal, the reference signal, and the model parameter of the equivalent power amplifier.

With reference to the third aspect, in some implementations of the third aspect, the configuration information of the reference signal includes one or more of the following: type information of the reference signal, sequence information of the reference signal, time-frequency resource information of the reference signal, or antenna port information for sending the reference signal, where the time-frequency resource information corresponds to the antenna port information. The configuration information of the reference signal may be used by the terminal device to determine (reconstruct) the reference signal of the digital channel.

With reference to the third aspect, in some implementations of the third aspect, the model parameter includes at least one of a nonlinear order, a memory depth, a cross-term length, or a model type.

With reference to the third aspect, in some implementations of the third aspect, the first configuration information further indicates bandwidth information of the reference signal. Based on the bandwidth information of the reference signals, the terminal device can fully obtain out-of-band information of signals obtained from the reference signals amplified by the power amplifiers, or accurately set a width of a band-pass filter, to implement a band-limited nonlinear model estimation algorithm, thereby improving accuracy of the determined model coefficient of the equivalent power amplifier.

With reference to the third aspect, in some implementations of the third aspect, each of the power amplifiers is connected to one digital channel of the network device. The method may be applicable to a PCS architecture.

According to a fourth aspect, an information measurement method is provided. The method may be performed by a chip or a chip system on a network device side. The method includes: A network device sends first configuration information to a terminal device, where the first configuration information indicates configuration information of a reference signal. The network device sends second configuration information to the terminal device, where the second configuration information indicates a model parameter of an equivalent power amplifier connected to a digital channel of the network device. The network device sends the reference signal to the terminal device through at least one physical antenna corresponding to the digital channel, where the power amplifier is connected to the physical antenna in a one-to-one correspondence. The network device receives a model coefficient of an equivalent power amplifier sent by the terminal device, where the equivalent power amplifier is an equivalent power amplifier of power amplifiers connected to the digital channel, and the receiving signal is the reference signal received by the terminal device.

The method provided in the fourth aspect is a method on a network device side corresponding to the third aspect. For its beneficial effects, directly refer to the third aspect.

With reference to the fourth aspect, in some implementations of the fourth aspect, the configuration information of the reference signal includes one or more of the following: type information of the reference signal, sequence information of the reference signal, time-frequency resource information of the reference signal, or antenna port information for sending the reference signal, where the time-frequency resource information corresponds to the antenna port information. The configuration information of the reference signal may be used by the terminal device to determine (reconstruct) the reference signal of the digital channel.

With reference to the fourth aspect, in some implementations of the fourth aspect, the model parameter includes at least one of a nonlinear order, a memory depth, a cross-term length, or a model type.

With reference to the fourth aspect, in some implementations of the fourth aspect, the first configuration information further indicates bandwidth information of the reference signal. Based on the bandwidth information of the reference signals, the terminal device can fully obtain out-of-band information of signals obtained from the reference signals amplified by the power amplifiers, or accurately set a width of a band-pass filter, to implement a band-limited nonlinear model estimation algorithm, thereby improving accuracy of the model coefficient of the equivalent power amplifier that is determined by the terminal device.

With reference to the fourth aspect, in some implementations of the fourth aspect, the method further includes: The network device determines, based on the model coefficient of the equivalent power amplifier and the reference signal, a digital predistortion coefficient corresponding to the digital channel.

With reference to the fourth aspect, in some implementations of the fourth aspect, that the network device determines, based on the model coefficient of the equivalent power amplifier and the reference signal, a digital predistortion coefficient corresponding to the digital channel includes: The network device determines the receiving signal of the terminal device based on the model coefficient of the equivalent power amplifier, the reference signal, and the model parameter of the equivalent power amplifier. The network device determines, based on the receiving signal and the reference signal, the digital predistortion coefficient corresponding to the digital channel.

With reference to the fourth aspect, in some implementations of the fourth aspect, each of the power amplifiers is connected to one digital channel of the network device. The method may be applicable to a PCS architecture.

According to a fifth aspect, a communication apparatus is provided. The apparatus may be used in the terminal device according to the first aspect. The apparatus includes: a transceiver unit, configured to implement receiving and sending functions in the method according to the first aspect; and a processing unit, configured to implement processing functions such as determining a model coefficient of an equivalent power amplifier in the method according to the first aspect.

According to a sixth aspect, a communication apparatus is provided. The apparatus may be used in the network device according to the second aspect. The apparatus includes: a transceiver unit, configured to implement receiving and sending functions in the method according to the second aspect; and a processing unit, configured to implement processing functions such as determining a digital predistortion coefficient corresponding to a digital channel in the method according to the second aspect.

According to a seventh aspect, a communication apparatus is provided. The apparatus may be used in the terminal device according to the third aspect. The apparatus includes: a transceiver unit, configured to implement receiving and sending functions in the method according to the third aspect; and a processing unit, configured to implement processing functions such as determining a model coefficient of an equivalent power amplifier in the method according to the third aspect.

According to an eighth aspect, a communication apparatus is provided. The apparatus may be used in the network device according to the fourth aspect. The apparatus includes: a transceiver unit, configured to implement receiving and sending functions in the method according to the fourth aspect; and a processing unit, configured to implement processing functions such as determining a digital predistortion coefficient corresponding to a digital channel in the method according to the fourth aspect.

According to a ninth aspect, a communication apparatus is provided, including a processor and an interface circuit. The interface circuit is configured to receive a signal from another communication apparatus and transmit the signal to the processor, or send a signal from the processor to another communication apparatus. The processor implements the method in any one of the first aspect to the fourth aspect or the possible implementations of the first aspect to the fourth aspect by using a logic circuit or executing code instructions.

According to a tenth aspect, a communication system is provided, including: the terminal device in the method according to the first aspect and another communication device that communicates with the terminal device; and the network device in the method according to the second aspect and another communication device that communicates with the network device.

According to an eleventh aspect, a communication system is provided, including: the terminal device in the method according to the third aspect and another communication device that communicates with the terminal device; and the network device in the method according to the fourth aspect and another communication device that communicates with the network device.

According to a twelfth aspect, a computer-readable storage medium is provided. The computer-readable medium stores a computer program. When the computer program is run on a computer, the method in any one of the first aspect to the fourth aspect or the possible implementations of the first aspect to the fourth aspect is performed.

According to a thirteenth aspect, a computer program product is provided, including a computer program. When the computer program is executed, the communication method in any one of the first aspect to the fourth aspect or the possible implementations of the first aspect to the fourth aspect is implemented.

The solutions provided in the fifth aspect to the thirteenth aspect are used to implement or cooperate to implement the methods provided in the first aspect to the fourth aspect, and therefore, can achieve beneficial effects the same as or corresponding to those in the first aspect to the fourth aspect. Details are not described herein again.

## BRIEF DESCRIPTION OF DRAWINGS

FIG. 1 is a diagram of a network architecture to which an embodiment of this application is applicable;
FIG. 2 is a diagram of basic principles of DPD;
FIG. 3 is a diagram of obtaining DPD coefficients based on a feedback channel;
FIG. 4 is a diagram of a PCS;
FIG. 5 is a diagram of an FCS;
FIG. 6 is a diagram of determining DPD coefficients in an HBF FCS architecture;
FIG. 7 is a diagram of measuring and feeding back a DPD coefficient by a remote device;
FIG. 8 is a diagram of an equivalent architecture of PAs connected to one digital channel in a PCS structure;
FIG. 9 is a schematic interaction flowchart of an information measurement method according to an embodiment of this application;
FIG. 10 is a diagram of obtaining DPD coefficients corresponding to digital channels in an HBF FCS architecture according to an embodiment of this application;
FIG. 11 is a schematic interaction flowchart of obtaining DPD coefficients corresponding to digital channels in an HBF FCS architecture according to an embodiment of this application;
FIG. 12 is a diagram of a time-frequency structure of a reference signal according to an embodiment of this application;
FIG. 13 is a diagram of periodically sending reference signals through different digital channels;
FIG. 14 is a schematic interaction flowchart of an information measurement method according to an embodiment of this application;

FIG. 15 is a diagram of obtaining DPD coefficients corresponding to digital channels in an HBF PCS architecture according to an embodiment of this application;

FIG. 16 is a diagram of performing, by terminal devices, feedback of model coefficients of equivalent PAs in different beam areas according to an embodiment of this application;

FIG. 17 is a schematic interaction flowchart of obtaining DPD coefficients corresponding to digital channels in an HBF PCS architecture according to an embodiment of this application;

FIG. 18 is a diagram of sending the same reference signal through different digital channels according to an embodiment of this application;

FIG. 19 is another diagram of sending different reference signals through different digital channels according to an embodiment of this application;

FIG. 20 is a diagram illustrating that an input signal passes through a DPD module and a PA; and

FIG. 21 to FIG. 25 are block diagrams of a communication apparatus according to an embodiment of this application.

## DESCRIPTION OF EMBODIMENTS

The following describes technical solutions of this application with reference to the accompanying drawings.

Embodiments of this application may be applied to various communication systems, for example, a wireless local area network (wireless local area network, WLAN) system, a narrowband internet of things (narrowband internet of things, NB-IoT) system, a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a code division multiple access 2000 (code division multiple access, CDMA2000) system, a time division synchronous code division multiple access (time division synchronous code division multiple access, TD-SCDMA) system, a long term evolution (long term evolution, LTE) system, satellite communication, a sidelink (sidelink, SL), a fourth generation (fourth generation, 4G) system, a fifth generation (5th generation, 5G) system, or a new communication system emerging in the future. A communication system includes communication devices, and the communication devices may perform wireless communication by using an air interface resource. The communication devices may include a network device and a terminal device. The network device may also be referred to as a base station device. A structure of the base station device includes: an input apparatus, an output apparatus, a processor, and a memory. A structure of the terminal device includes: an input apparatus, an output apparatus, a processor, and a memory. The air interface resource may include at least one of a time domain resource, a frequency domain resource, a code resource, and a spatial resource.

The terminal device may be a wireless terminal device that can receive scheduling and indication information of the network device. The wireless terminal device may be a device that provides a user with voice and/or data connectivity, or a handheld device with a wireless connection function, or another processing device connected to a wireless modem.

The terminal device in embodiments of this application may include various handheld devices, in-vehicle devices, wearable devices, or computing devices that have a wireless communication function, or other processing devices connected to a wireless modem. A terminal may be a subscriber unit (subscriber unit), user equipment (user equipment, UE), a cellular phone (cellular phone), a smartphone (smartphone), a cordless phone, a conference initiation protocol (session initiation protocol, SIP), a wireless data card, a wireless local loop (wireless local loop, WLL) station, a personal digital assistant (personal digital assistant, PDA) computer, a tablet computer, a wireless modem (modulator demodulator, modem), a laptop computer (laptop computer), a machine type communication (machine type communication, MTC) terminal, a wireless terminal in self driving (self driving), or the like. The user equipment includes vehicle user equipment. With emergence of an internet of things (internet of things, IOT) technology, a growing number of devices that previously do not have a communication function, for example, but not limited to, a household appliance, a transportation vehicle, a tool device, a service device, and a service facility, start to obtain a wireless communication function by being configured with a wireless communication unit, to access a wireless communication network and accept remote control. This type of device has a wireless communication function because the device is configured with a wireless communication unit. Therefore, this type of device also belongs to a scope of wireless communication devices. In addition, the terminal device may be a mobile station (mobile station, MS), a mobile device, a mobile terminal, a wireless terminal, a handheld device (handset), a client, a virtual reality (virtual reality, VR) terminal device, an augmented reality (augmented reality, AR) terminal device, a wireless terminal in industrial control (industrial control), a wireless terminal in an Internet of vehicles, a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home, or the like. For example, the wireless terminal in the Internet of vehicles may be an in-vehicle device, an entire vehicle device, an in-vehicle module, a vehicle, or the like. The wireless terminal in industrial control may be a camera, a robot, or the like. The wireless terminal in the smart home may be a television, an air conditioner, a sweeper, a speaker, a set-top box, or the like. In embodiments of this application, an apparatus configured to implement a function of a terminal device may be a terminal device, or may be an apparatus that can support the terminal device in implementing the function, for example, a chip system. The apparatus may be installed in the terminal device. In embodiments of this application, the chip system may include a chip, or may include a chip and another discrete component.

The network device may be a device in a wireless network. For example, the network device is a device that is deployed in a radio access network and that provides a wireless communication function for the terminal device. For example, the network device may be a radio access network (radio access network, RAN) node that connects the terminal device to the wireless network, and may also be referred to as an access network device.

The network device includes but is not limited to: a base transceiver station (base transceiver station, BTS) in a global system for mobile communications (global system for mobile communications, GSM) or a code division multiple access (code division multiple access, CDMA) network, or may be a NodeB (NodeB, NB) in wideband code division multiple access (wideband code division multiple access, WCDMA), or may be an evolved NodeB (evolved NodeB, eNB), a radio network controller (radio network controller, RNC), an NB, a base station controller (base station controller, BSC), a base transceiver station (base transceiver station, BTS), a home base station (for example, a home evolved NodeB, or a home NodeB, HNB), a baseband unit (baseband unit, BBU), an access point (access point, AP) in a wireless fidelity (wireless fidelity, Wi-Fi) system, a wireless relay node, a wireless backhaul node, a transmission point (transmission point, TP), a transmission reception point (transmission reception point, TRP), or the like, or may be a network device in a 5G mobile communication system. For example, the network device may be a next generation NodeB (next generation NodeB, gNB), a transmission reception point (transmission reception point, TRP), or a transmission point (transmission point, TP) in an NR system; or one antenna panel or one group of antenna panels (including a plurality of antenna panels) of a base station in the 5G mobile communication system. Alternatively, the network device may be a network node that forms a gNB or a transmission point, for example, a baseband unit (baseband unit, BBU) or a distributed unit (distributed unit, DU).

In some deployments, the gNB may include a central unit (central unit, CU) and a DU. The gNB may further include an active antenna unit (active antenna unit, AAU). The CU implements some functions of the gNB, and the DU implements some functions of the gNB.

For example, the CU is responsible for processing a non-real-time protocol and service, and implements functions of a radio resource control (radio resource control, RRC) layer and a packet data convergence protocol (packet data convergence protocol, PDCP) layer. The DU is responsible for processing a physical layer protocol and a real-time service, and implements functions of a radio link control (radio link control, RLC) layer, a media access control (media access control, MAC) layer, and a physical (physical, PHY) layer. The AAU implements some physical layer processing functions, radio frequency processing, and a function related to an active antenna. The information at the RRC layer is finally changed to the information at the PHY layer, or is changed from the information at the PHY layer. Therefore, in this architecture, the higher layer signaling (for example, the RRC layer signaling) may also be considered to be sent by the DU, or sent by the DU and the AAU. It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application.

For ease of understanding embodiments of this application, the following first briefly describes several terms used in this application.

1. Beam

A beam may be represented in an NR protocol as a spatial domain filter (spatial domain filter), or be referred to as a spatial filter (spatial filter), a spatial domain parameter (spatial domain parameter), a spatial parameter (spatial parameter), a spatial domain setting (spatial domain setting), a spatial setting (spatial setting), quasi-colocation (quasi-colocation, QCL) information, a QCL assumption, a QCL indication, or the like. The beam may be indicated by a transmission configuration indicator state (transmission configuration indicator state, TCI-state) parameter or a spatial relation (spatial relation) parameter. Therefore, in this application, the beam may be replaced with a spatial domain filter, a spatial filter, a spatial domain parameter, a spatial parameter, a spatial domain setting, a spatial setting, QCL information, a QCL assumption, a QCL indication, a TCI-state (including an uplink TCI-state or a downlink TCI-state), a spatial relationship, or the like. The foregoing terms are also equivalent to each other. Alternatively, the beam may be replaced with another term representing a beam. This is not limited in this application.

A beam used to transmit a signal may be referred to as a transmission beam (transmission beam, Tx beam), or may be referred to as a spatial domain transmission filter (spatial domain transmission filter), a spatial transmission filter (spatial transmission filter), a spatial domain transmission parameter (spatial domain transmission parameter), a spatial transmission parameter (spatial transmission parameter), a spatial domain transmission setting (spatial domain transmission setting), or a spatial transmission setting (spatial transmission setting). A downlink transmit beam may be indicated by a TCI-state.

A beam used to receive a signal may be referred to as a reception beam (reception beam, Rx beam), or may be referred to as a spatial domain reception filter (spatial domain reception filter), a spatial reception filter (spatial reception filter), a spatial domain reception parameter (spatial domain reception parameter), a spatial reception parameter (spatial reception parameter), a spatial domain reception setting (spatial domain reception setting), or a spatial reception setting (spatial reception setting). An uplink transmission beam may be indicated by the spatial relationship, an uplink TCI-state, or a channel sounding reference signal (sounding reference signal, SRS) resource (indicating a transmission beam using this SRS). Therefore, the uplink beam may alternatively be replaced with the SRS resource.

The transmit beam may be distribution of signal strength formed in different directions in space after signal transmission is performed by an antenna, and the receive beam may be distribution of signal strength, in different directions in space, of a radio signal received from an antenna.

In addition, the beam may be a wide beam, a narrow beam, or a beam of another type. A technology for forming the beam may be a beamforming technology or another technology. The beamforming technology may be specifically a digital beamforming technology, an analog beamforming technology, a hybrid digital beamforming technology, a hybrid analog beamforming technology, or the like.

The beam corresponds to configuration information of the reference signal. For example, during beam measurement, the network device may determine quality of different beams based on quality of different reference signals. The terminal device measures the reference signal, and feeds back quality of the reference signal to the network device. The network device may determine quality of the beam based on the quality of the reference signal. For the configuration information of the reference signal, refer to the following related descriptions. During data transmission, the beam information is also indicated by configuration information of a reference signal corresponding to the beam information. For example, the network device indicates information about a physical downlink shared channel (physical downlink shared channel, PDSCH) beam of the terminal device by using a TCI field in downlink control information (downlink control information, DCI). In a possible implementation, a plurality of beams having the same or similar communication characteristics are considered as one beam.

2. Configuration information of a reference signal

The configuration information of the reference signal includes a related parameter of the reference signal, for example, a transmission periodicity and a used time-frequency resource of the reference signal. The reference signal may be an uplink reference signal or a downlink reference signal. The uplink reference signal includes but is not limited to a sounding reference signal (sounding reference signal, SRS) and a demodulation reference signal (demodulation reference signal, DMRS). The downlink reference signal includes but is not limited to a channel state information-reference signal (channel state information-reference signal, CSI-RS), a cell-specific reference signal (cell-specific reference signal, CS-RS), a UE-specific reference signal (user equipment-specific reference signal, US-RS), a demodulation reference signal (demodulation reference signal, DMRS), and a synchronization signal/physical broadcast channel block (synchronization system/physical broadcast channel block, SS/PBCH block). The SS/PBCH block may be referred to as a synchronization signal block (synchronization signal block, SSB) for short.

The configuration information of the reference signal may be configured through RRC signaling. In terms of a configuration structure, the configuration information of the reference signal corresponds to a data structure, and includes a related parameter of an uplink reference signal or a related parameter of a downlink reference signal corresponding to the data structure. For example, for the uplink reference signal, the configuration information of the reference signal includes at least one of the following: a type of the uplink reference signal, a resource element (which may also be referred to as a time-frequency resource) for carrying the uplink reference signal, a transmission time and a transmission periodicity of an uplink channel, an antenna port configured to send the uplink reference signal, and the like. For the downlink reference signal, the configuration information of the reference signal includes at least one of the following: a type of the downlink reference signal, a resource element (which may also be referred to as a time-frequency resource) for carrying the downlink reference signal, a transmission time and a transmission periodicity of the downlink reference signal, an antenna port configured to send the downlink reference signal, and the like. In this application, the resource may be understood as a time-frequency resource that is configured in the configuration information of the reference signal and that is used to carry the reference signal. Each resource corresponds to a corresponding antenna port, and the antenna port is specifically represented by the configuration information of the reference signal.

In this application, the resource may be understood as a time-frequency resource that is configured in the configuration information of the reference signal and that is used to carry the reference signal.

3. Power amplifier model

Power amplifier models include a polynomial (polynomial, P) model, a memory polynomial (memory polynomial, MP) model, and a generalized memory polynomial (generalized memory polynomial, GMP) model. It is assumed that $x(n)$

represents an input signal of a power amplifier, r(n) represents an output signal of the power amplifier, and $c_k$, $c_{km}$, $a_{kmg}$, and $b_{kmg}$ represent model coefficients of the power amplifier; $K$ represents a highest nonlinear order, $M$ represents a maximum memory depth, G represents a maximum cross-term length, and $n$ represents an instant.

The polynomial model may be represented by the following formula (1):

$$r(\mathrm{n}) = \sum_{k=1}^{K} c_k \left| x(n) \right|^{k-1} x(n) \qquad (1)$$

where $c_k$ is a model coefficient of the polynomial model, and k is a nonlinear order.

The memory polynomial model may be represented by the following formula (2):

$$r(\mathrm{n}) = \sum_{k=1}^{K} \sum_{m=0}^{M-1} c_{km} \left| x(n-m) \right|^{k-1} x(n-m) \qquad (2)$$

where $c_{km}$ is a model coefficient of the memory polynomial model, k is a nonlinear order, and m is a memory depth.

The generalized memory polynomial model may be represented by the following formula (3):

$$r(\mathrm{n}) = \sum_{k=1}^{K} \sum_{m=0}^{M-1} c_{km} \left| x(n-m) \right|^{k-1} x(n-m)$$

$$+ \sum_{k=1}^{K} \sum_{m=0}^{M-1} \sum_{g=1}^{G} \left[ a_{kmg} \left| x(n-m) \right|^{k-1} x(n-m-g) \right]$$

$$+ b_{kmg} \left| x(n-m) \right|^{k-1} x(n-m+g) \qquad (3)$$

where $c_{km}$, $a_{kmg}$, and $b_{kmg}$ are model coefficients of the generalized memory polynomial model, $k$ is a nonlinear order, $m$ is a memory depth, and g is a cross-term length.

The terms and concepts involved in embodiments of this application are described above. A scenario to which an information measurement method according to an embodiment of this application is applied will be described below.

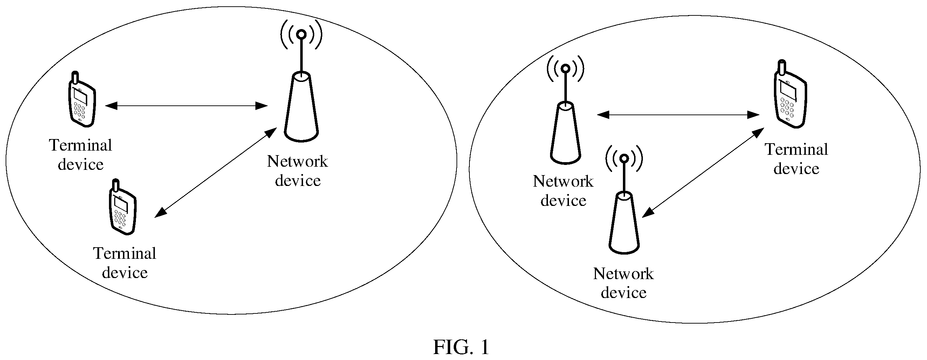

FIG. 1 is a diagram of a network architecture to which an embodiment of this application is applicable. The network architecture includes one or more network devices and one or more terminal devices. One network device may transmit data or control signaling to one or more terminal devices. Alternatively, a plurality of network devices may simultaneously transmit data or control signaling to one terminal device.

In embodiments of this application, a transmitter of the network device may use an analog beamforming (analog beamforming, ABF) or hybrid beamforming system architecture. Embodiments of this application are applicable to a scenario with a strong coverage capability and low transmitting-end energy consumption, such as enhanced mobile broadband (enhanced mobile broadband, eMBB) and massive machine-type communication (massive machine-type communication, mMTC). A waveform of a signal transmitted between the network device and the terminal device is not limited in embodiments of this application either. Embodiments of this application may be applied to a communication system of cyclic prefix orthogonal frequency division multiplexing (cyclic prefix-orthogonal frequency division multiplexing, CP-OFDM) or discrete Fourier transform spread orthogonal frequency division multiplexing (discrete Fourier transform-spread-OFDM, DFT-s-OFDM).

The scenario to which an information measurement method according to an embodiment of this application is applied is described above. The technical solutions related to embodiments of this application will be described below.

A PA can amplify a low-power signal generated by a network device or a terminal device to a power level capable of long-range transmission. A PA is a core component of a wireless communication device. During power amplification, the PA may introduce nonlinear distortion, leading to deterioration in a performance indicator of an output signal. For example, the nonlinear distortion caused by the PA may lead to performance deterioration in an EVM and an ACLR of the output signal.

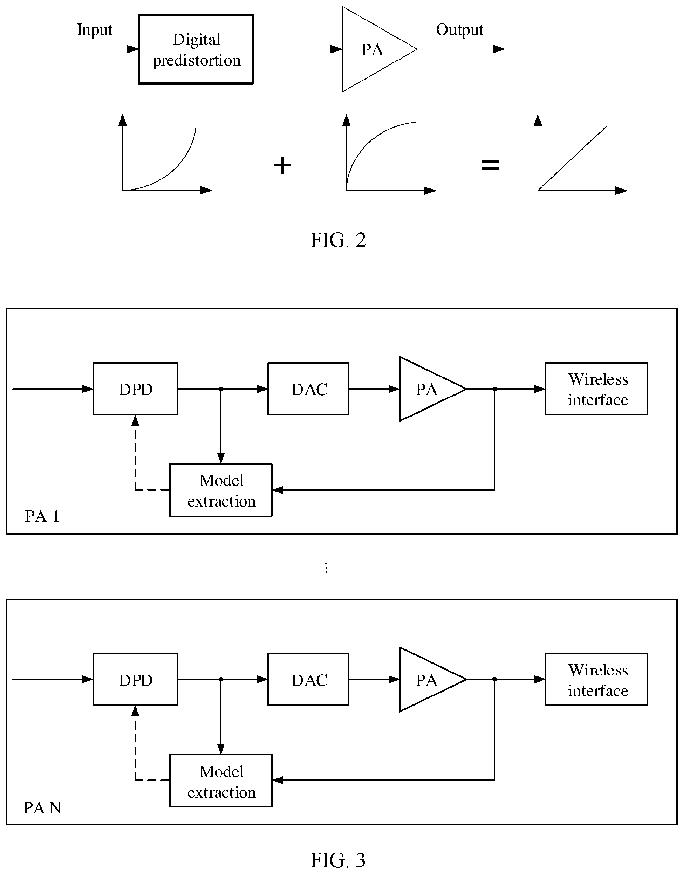

A digital predistortion technique is an effective means of improving linearity of an output signal of a PA, with its basic principles being performing digital preprocessing on an original signal of a digital channel before the PA performs power amplification on the original signal, to improve the linearity of the output signal of the PA. Theoretically, a function corresponding to DPD is an inverse function of a response function of the PA. FIG. 2 is a diagram of basic principles of DPD.

Before performing digital predistortion, a transmitter of a network device needs to obtain a DPD coefficient through a pre-PA signal and a post-PA signal. The pre-PA signal is a signal prior to amplification by a power amplifier, and may also be referred to as an original signal of a digital channel. The post-PA signal is a signal after the amplification by the power amplifier. The pre-PA signal may be directly obtained at a digital module, for example, obtained at a digital-to-analog converter (digital-to-analog converter, DAC). In some scenarios, for example, a low-frequency scenario, the transmitter may acquire the post-PA signal through a feedback channel. FIG. 3 is a diagram of obtaining DPD coefficients based on a feedback channel. When a transmitter has a plurality of PAs, each PA may have an independent feedback channel, to obtain an independent DPD coefficient.

In a frequency band such as millimeter waves, a network device (a transmitting device) may use more physical antennas to obtain an array gain, to counteract a larger propagation loss of a high-frequency signal. For example, there may be hundreds or thousands of antenna elements included in a network device with a frequency band of 26 GHz to 28 GHz, where one physical antenna includes a plurality of antenna elements. To avoid excessively high costs and power consumption caused by a large-scale array, the network device may use an HBF architecture. In the HBF architecture, a quantity of digital channels is far less than that of physical antennas. In embodiments of this application, a digital channel may also be referred to as a digital radio frequency link.

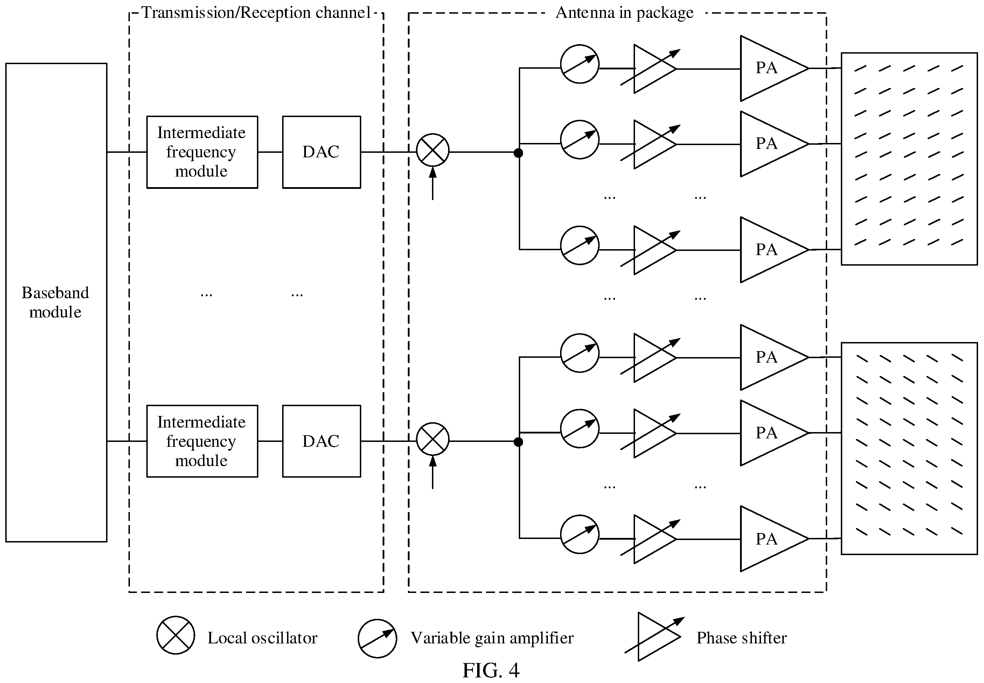

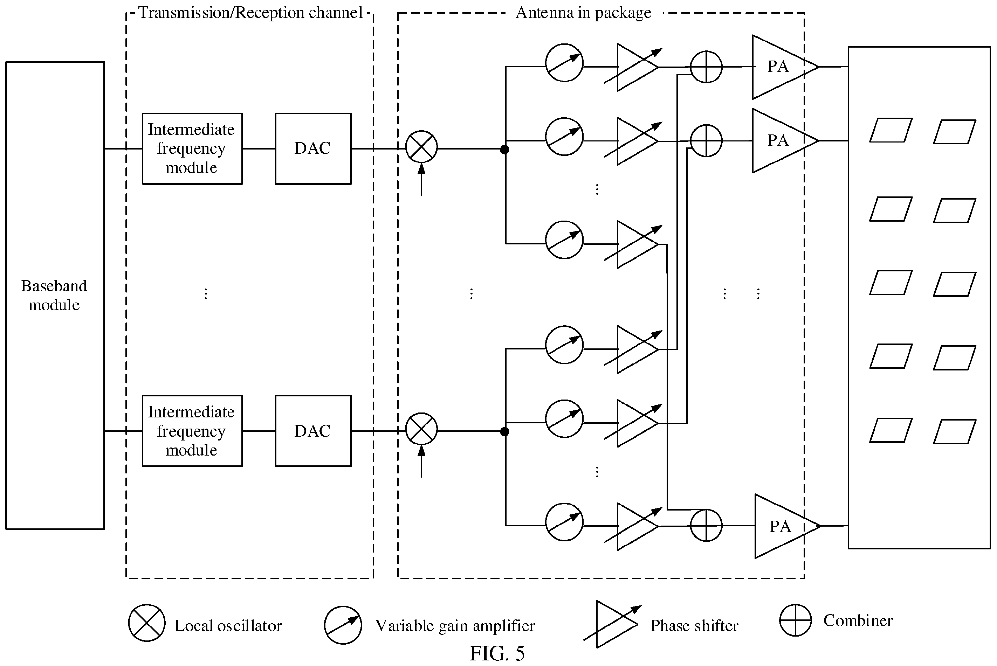

In NR, the HBF architecture may be usually divided into two hardware design structures. One is a partially connected structure, where each digital channel is connected to all physical antennas of only one subarray. FIG. 4 is a diagram of a PCS, where a baseband module may perform modulation, source coding, channel coding, filtering, and the like on a signal. The other is a fully connected structure, where each digital channel is connected to all physical antennas of all subarrays. FIG. 5 is a diagram of an FCS. Apparently, in the FCS structure, each digital channel is connected to more physical antennas, and a coverage capability of millimeter waves is better. However, additional phase shifters and combiners are required, which causes an increase in hardware complexity and cost.

Regardless of which structure is used, digital predistortion needs to be implemented on the digital channel, for example, an intermediate frequency module in FIG. 4 or FIG. 5. For the HBF PCS architecture, one digital channel may correspond to a plurality of PAs, and DPD compensation cannot be implemented for the PAs one by one. For the HBF FCS architecture, each PA is connected to all digital channels, an output of the PA is a nonlinear combination of all digital channel signals, and an input of a DPD module needs to take into account signals on all digital channels. Therefore, a conventional DPD coefficient obtaining and compensation method cannot be directly applied to an HBF architecture due to problems such as a large power back-off and poor linearity of an output signal.

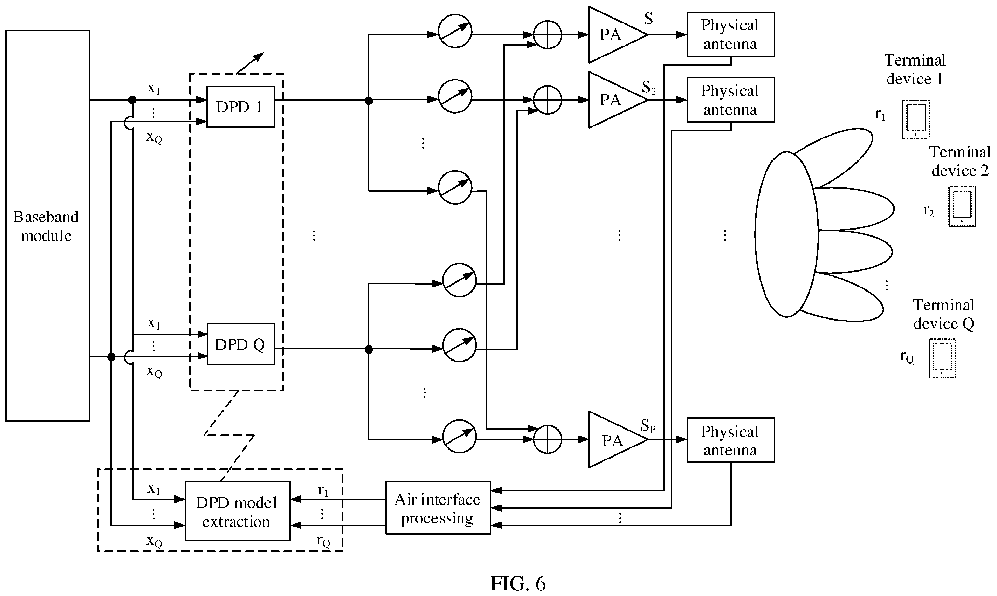

Currently, for the HBF FCS architecture, a DPD module may be added to each digital channel based on an original signal of each digital channel and feedback signals of all physical antennas, to correct nonlinear distortion of a post-PA signal. FIG. 6 is a diagram of determining DPD coefficients in an HBF FCS architecture. There are a total of Q digital channels in the fully connected structure, each of the $P$ power amplifiers is connected to all the digital channels, $P$ physical antennas are connected to the $P$ power amplifiers in a one-to-one correspondence, and $P$ physical antenna transmission signals serve Q terminal devices/users, where Q is a positive integer greater than 1, and $P$ is a positive integer greater than Q.

It is assumed that a channel response coefficient from a $p^{th}$ physical antenna to a $q^{th}$ terminal device is $h_{pq}$. By default, the parameter is known to the transmitting end/network device. Specifically, a channel response coefficient from a physical antenna to a terminal device may be estimated by using a sounding reference signal (sounding reference signal, SRS) or a channel state information reference signal (channel state information-reference signal, CSI-RS). An output signal of the $p^{th}$ physical antenna is $S_p(n)$, and an original signal of a $q^{th}$ digital channel is $x_q(n)$. The PA is modeled by using a memory polynomial model, in which case a receiving signal $r_q(n)$ of the $q^{th}$ terminal device may be represented by the following formula (4):

$$r_q(n) = \sum_{p=1}^{P} h_{pq} S_p(n)$$

$$= \sum_{p=1}^{P} \sum_{m=0}^{M} \sum_{k=0}^{K} h_{pq} c_{km}^{p} \left( \sum_{q}^{Q} w_{pq} x_q(n-m) \right) \times \left| \sum_{q}^{Q} w_{pq} x_q(n-m) \right|^{2k} \qquad (4)$$

where $w_{pq}$ is an analog beamforming coefficient from the $p^{th}$ physical antenna to the $q^{th}$ terminal device, $k$ is a nonlinear order of the PA model, $m$ is a memory depth of the PA model, $c_{km}^{p}$ is a PA model coefficient of a corresponding order, and $n$ represents an instant. An objective of the analog beamforming is also to direct a beam corresponding to a digital channel signal to a corresponding target terminal device. Therefore, the formula (4) may be written as the following formula (5):

$$\sum_{q=1}^{Q} r_q\left(n\right) = \sum_{p=1}^{P} h_{pq} w_{p1} \times \left[ x_1 \cdot f_1\left(x_1, x_2, \cdots, x_Q\right) \right] + \sum_{p=1}^{P} h_{pq} w_{p2} \times \left[ x_2 \cdot f_2\left(x_1, x_2, \cdots, x_Q\right) \right] + \cdots$$

$$+ \sum_{p=1}^{P} h_{pq} w_{pQ} \times \left[ x_Q \cdot f_Q\left(x_1, x_2, \cdots, x_Q\right) \right] + \sum_{p=1}^{P} h_{pq} \times \left[ f_{Q+1}\left(x_1, x_2, \cdots, x_Q, \omega_{P1}, \omega_{P2}, \cdots, \omega_{PQ}\right) \right] \quad (5)$$

There are a total of Q+1 terms on the right of the equal sign of the formula (5), where the first Q terms are primary branch signals received by the terminal device, and it is assumed that the primary branch signals do not interfere with each other. A primary branch signal received by the $q^{\text{th}}$ terminal device is $\sum_{p=1}^{P} h_{pq} w_{pq} \times \left[ x_q \cdot f_q\left(x_1, x_2, \cdots, x_Q\right) \right]$ . The (Q+1)$^{\text{th}}$ term is a secondary branch signal. The terminal device may receive the secondary branch signal only under specific conditions, and in most cases, the secondary branch signal may be ignored.

In FIG. 6, the network device obtains an output signal of each physical antenna through wired feedback, and then obtains receiving signals $r_1, r_2, ..., r_Q$ of the Q terminal devices based on the estimated channel response coefficient and the foregoing formula (4) or (5). The primary branch signals in formula (5) are all generated through a nonlinear combination of $x_1, x_2, ..., x_Q$. According to the indirect learning idea, a digital predistortion model is an inverse model of the PA, so that input signals of a digital predistortion model of the $q^{\text{th}}$ digital channel are respectively $r_1, r_2, ..., r_Q$, and an output signal of the digital predistortion model of the $q^{\text{th}}$ digital channel is $x_q$. Then, a DPD coefficient may be estimated by using a least squares (least squares, LS) algorithm. Each digital channel corresponds to an independent digital predistortion module, to correct nonlinear distortion caused by the PA.

In the HBF FCS architecture, the network device reconstructs a receiving signal of a terminal device using an estimated channel response coefficient and an output signal that is of the physical antenna and that is obtained through wired feedback, and finally determines, based on the original signal of the digital channel and the receiving signal of the terminal device, a DPD coefficient corresponding to the digital channel. In this process, the channel response coefficient estimated by the network device may have a large error, and the reconstructed receiving signal of the terminal device deviates from an actual receiving signal of the terminal device. As a result, the determined DPD coefficient has low accuracy. In addition, when there are a large quantity of physical antennas, hardware costs for wired feedback are high, leading to high costs in determining the DPD coefficient.

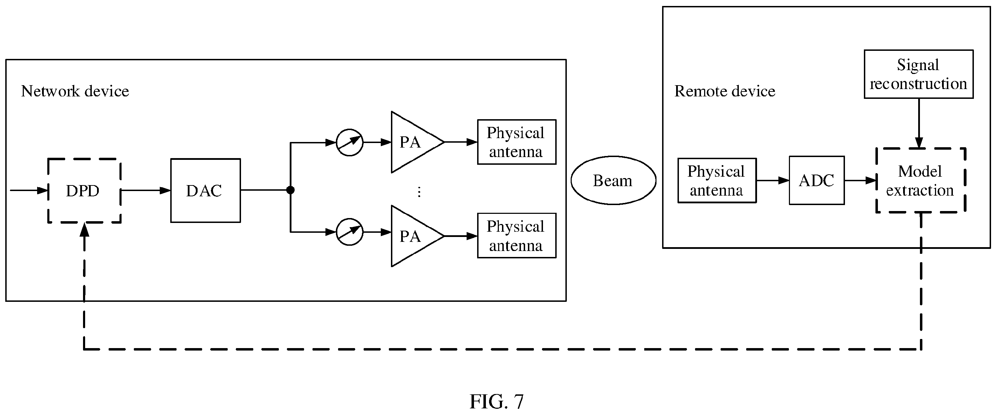

Currently, for the HBF PCS architecture, a DPD coefficient may be measured and fed back based on a remote device. The DPD coefficient fed back by the remote device may be referred to as an over the air (over the air, OTA) DPD coefficient. The remote device may be a terminal device. FIG. 7 is a diagram of measuring and feeding back a DPD coefficient by a remote device. The remote device receives a signal transmitted by a physical antenna of a network device, and obtains a DPD coefficient of the network device based on a receiving signal. Specifically, the remote device obtains a receiving signal through an air interface. The receiving signal may be subjected to steps such as filtering, analog-to-digital conversion by an analog-to-digital converter (analog-to-digital converter, ADC), downsampling, channel estimation, and equalization, to obtain an equivalent post-PA signal, where the channel estimation includes obtaining a channel response coefficient, and equalization includes removing impact of the channel response coefficient on the receiving signal. Then, DPD coefficient training and parameter obtaining for a digital channel are performed based on the equivalent post-PA signal and a known pre-PA signal. The signal transmitted by the physical antenna of the network device is amplified by a plurality of PAs. Therefore, the receiving signal of the remote device includes combination of a plurality of PA nonlinear effects, so that the DPD coefficient obtained by the remote device can compensate for the plurality of PA nonlinear effects, thereby correcting nonlinear distortion caused by the PA.

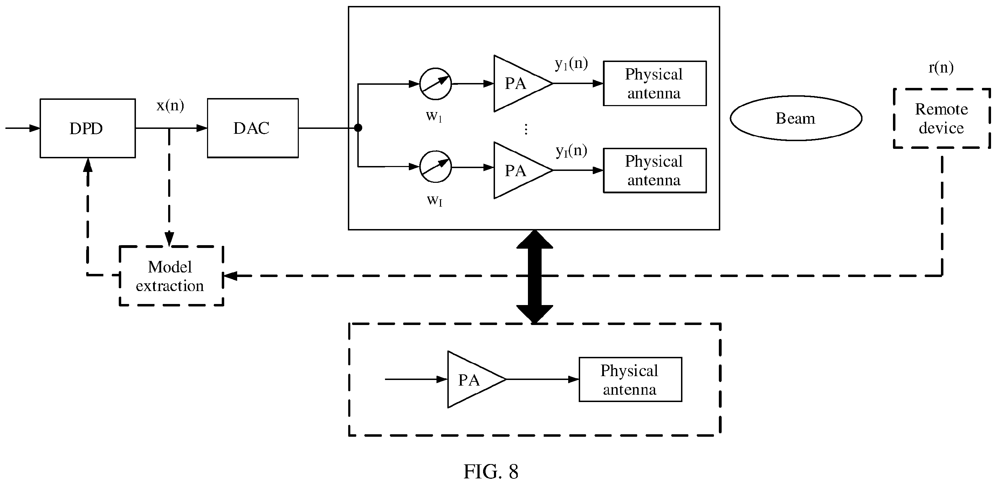

FIG. 8 is a diagram of an equivalent architecture of PAs connected to one digital channel in a PCS structure. One digital channel is connected to $I$ PAs, and each PA is connected to a physical antenna in a one-to-one correspondence. It is assumed that a pre-PA signal entering the digital channel is $x(n)$, an analog beamforming weight vector is W=[$w_1, w_2, \cdots,$ $w_I$]$^{\text{T}}$, the PA may be modeled by using a memory polynomial, and a model coefficient of an $i^{\text{th}}$ PA is $c_{km}^{i}$ . In this case, an output signal $y_i(n)$ of the $i^{\text{th}}$ PA may be represented by the following formula (6):

$$y_i\left(n\right) = \sum_{k=1}^{K} \sum_{m=0}^{M-1} c_{km}^{i} \left|w_i\right|^{2k} w_i \left|x\left(n-m\right)\right|^{2k} \cdot x\left(n-m\right) \quad (6)$$

Considering that the remote device receives a signal from the network device through one physical antenna, the receiving signal $r(n)$ of the remote device may be represented by the following formula (7):

$$r(\mathrm{n}) = \sum_{i=1}^{I} h_i y_i(n) = \sum_{i=1}^{I} h_i \sum_{k=1}^{K} \sum_{m=0}^{M-1} \beta_{km}^{i} \left| x(n-m) \right|^{2k} \cdot x \left| n-m \right|$$

$$= \sum_{k=1}^{K} \sum_{m=0}^{M-1} \gamma_{km} \left| x(n-m) \right|^{2k} \cdot x(n-m) \qquad (7)$$

where $h_i$ is a channel response coefficient from an $i^{th}$ physical antenna of the network device to a receive physical antenna

$$\gamma_{km} = \sum_{i=1}^{I} h_i \beta_{km}^{i} = \sum_{i=1}^{I} h_i c_{km}^{i} \left| w_i \right|^{2k} w_i$$

of the remote device, and , assuming that a magnitude of the weight $w_i$ is 1.

It can be learned from formula (6) and formula (7) that, at the remote device, the plurality of PAs connected to one digital channel of the network device may be equated to one PA, a model coefficient of a single PA is $c_{km}^{i}$, and a model coefficient of an equivalent PA connected to one digital channel is $\gamma_{km}$.

In the HBF PCS architecture, the network device compensates for a nonlinear effect of all PAs connected to a single digital channel, to ensure signal quality of a receiving signal of a remote device. However, in an actual NR system, in addition to a partially connected structure, the HBF architecture further includes a fully connected structure, and impact of intermodulation interference between different digital channels needs to be taken into account during correction of nonlinear distortion of the PA.

In the HBF FCS architecture, there may be up to hundreds or thousands of PAs. Each PA is connected to all digital channels to improve an array gain of a system, but intermodulation interference between the digital channels may be caused. Therefore, a method for determining DPD coefficients corresponding to digital channels one by one in the partially connected structure cannot be used. In an existing technical solution, to determine a DPD coefficient corresponding to each digital channel in the HBF FCS architecture, a network device needs to obtain an output signal of each physical antenna through wired feedback, and needs to estimate a channel response coefficient between each physical antenna and a terminal device and determine a receiving signal of the terminal device based on the output signal of each physical antenna and the channel response coefficient between each physical antenna and the terminal device. Then, the network device determines, based on the receiving signal of the terminal device, the digital predistortion coefficient corresponding to the digital channel. Implementation costs of the technical solution are relatively high, and accuracy of the determined DPD coefficient is low.

In view of this, an embodiment of this application provides an information measurement method. A terminal device may assist in obtaining a model coefficient of an equivalent PA of PAs connected to each digital channel of a network device, and the network device may determine, based on the model coefficient of the equivalent PA of the PAs connected to the digital channel that is reported by the terminal device, a DPD coefficient corresponding to the digital channel. The method can reduce the costs of determining the DPD coefficient and improve the accuracy of determining the DPD coefficient. Alternatively, the terminal device in embodiments of this application may be another device that can obtain the DPD coefficient corresponding to the digital channel of the network device. The network device in embodiments of this application may be a base station.

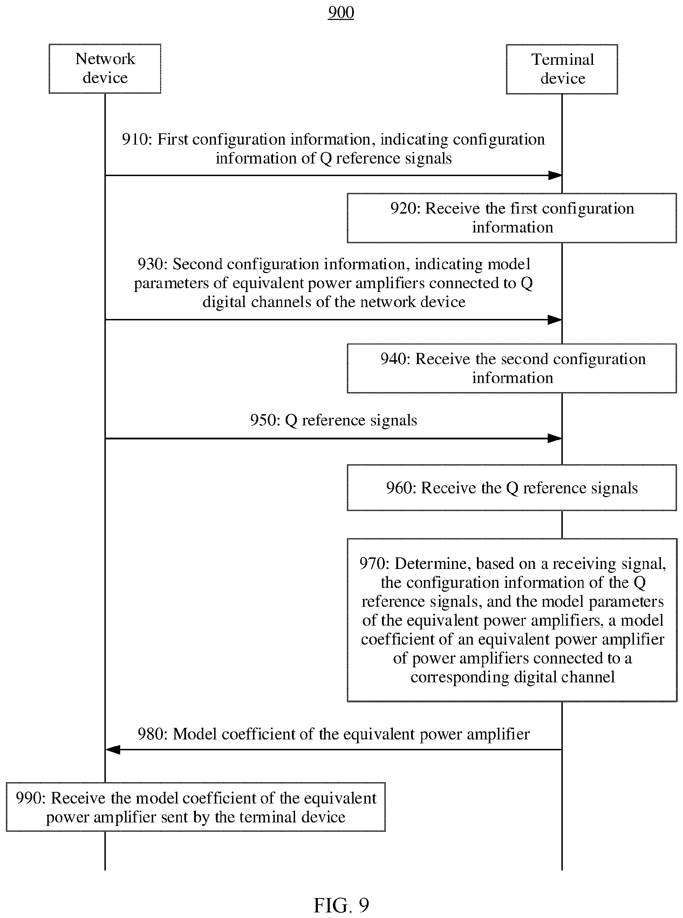

FIG. 9 is a schematic interaction flowchart of an information measurement method 900 according to an embodiment of this application. The method may be used in an HBF architecture or a digital beamforming (digital beam forming, DBF) architecture. A network device includes Q digital channels, and Q terminal devices are required to assist in obtaining DPD coefficients respectively corresponding to the Q digital channels. Q is an integer greater than 1.

910: The network device sends first configuration information to the Q terminal devices, where the first configuration information indicates configuration information of Q reference signals. Optionally, the first configuration information may be sent by the network device to the terminal device through radio resource control (radio resource control, RRC) signaling.

Optionally, the first configuration information includes one or more of the following: type information of the Q reference signals, sequence information of the Q reference signals, time-frequency resource information of the Q reference signals, or antenna port information for sending the Q reference signals. One digital channel corresponds to one antenna port, and time-frequency resource information is in a one-to-one correspondence with antenna port information. Each terminal device only needs to know antenna port information of a reference signal of a digital channel corresponding to the terminal device.

The Q reference signals are different reference signals. For example, types of the Q reference signals are different; or the types of the Q reference signals are the same, but sequence information of the Q reference signals is different. Because intermodulation interference exists between digital channel signals in a fully connected structure, reference signals sent through the digital channels should be different, to ensure non-singularity of a model matrix when the terminal device performs PA model training, thereby helping improve accuracy of the PA model training.

For example, the time-frequency resource information of the reference signal includes a time domain resource and a frequency domain resource that are used to carry the reference signal. Specifically, the time domain resource includes a transmission time, a transmission periodicity, a slot offset of the transmission time, and a quantity of time domain symbols occupied by the transmission time. Time-frequency resources used to carry different reference signals correspond to different antenna ports, and antenna port information may be reflected by the time-frequency resources of the reference signals.

920: Correspondingly, the Q terminal devices receive the first configuration information sent by the network device. The terminal device may reconstruct reference signals of different digital channels based on the first configuration information. A reference signal of a digital channel may be referred to as an original signal of the digital channel or a signal prior to amplification by a power amplifier.

930: The network device sends second configuration information to the Q terminal devices, where the second configuration information indicates model parameters of equivalent power amplifiers connected to the Q digital channels of the network device. Model parameters of all power amplifiers of the network device are the same, and model parameters of an equivalent power amplifier connected to each digital channel are the same as the model parameters of all the power amplifiers of the network device.

Optionally, the model parameters, indicated by the second configuration information, of the equivalent power amplifiers connected to the Q digital channels of the network device include at least one of a nonlinear order, a memory depth, a cross-term length, or a model type. Optionally, the model type of the equivalent power amplifier may be predefined, or may be indicated by the network device to the terminal device through the second configuration information.

For a single PA, polynomial, memory polynomial, and generalized memory polynomial models are often used for modeling. For the fully connected structure, a PA model in the HBF FCS architecture is slightly different from that of a single PA due to intermodulation interference between different channel signals. A fully connected-polynomial (fully connected-polynomial, FC-P) model, a fully connected-memory polynomial (fully connected-memory polynomial, FC-MP) model, or a fully connected-generalized memory polynomial (fully connected-generalized memory polynomial, FC-GMP) model may be used. The model type of the PA indicated by the second configuration information may be any one of the FC-P model, the FC-MP model, and the FC-GMP model. If the model type indicated by the second configuration information is the FC-P model, the model parameters indicated by the second configuration information further include a nonlinear order, that is, $M = G = 0$. If the model type indicated by the second configuration information is the FC-MP model, the model parameters indicated by the second configuration information further include a nonlinear order and a memory depth, that is, $G = 0$. If the model type indicated by the second configuration information is the FC-GMP model, the model parameters indicated by the second configuration information further include a nonlinear order, a memory depth, and a cross-term length.

Optionally, the Q digital channels of the network device are connected to respective corresponding power amplifiers. It may also be understood that each digital channel is connected to all physical antennas of all subarrays. This embodiment may be applied to the HBF FCS architecture.

The second configuration information may be sent by the network device to the terminal device through RRC signaling. The first configuration information and the second configuration information may be sent to the terminal device through the same RRC signaling, or may be sent to the terminal device through different RRC signaling.

940: Correspondingly, the Q terminal devices receive the second configuration information sent by the network device.

950: The network device sends Q reference signals to the Q terminal devices through P physical antennas. For example, the network device sends the Q reference signals to the Q terminal devices through the P physical antennas based on the time-frequency resource information of the Q reference signals. The power amplifiers are connected to the physical antennas in a one-to-one correspondence, where P is an integer greater than or equal to Q, and signals sent through the physical antennas are reference signals with amplified powers. The Q reference signals are simultaneously sent through the Q digital channels, and one reference signal is sent on each digital channel.

960: The Q terminal devices receive the Q reference signals sent by the network device, to obtain receiving signals. For example, the Q terminal devices receive, based on the time-frequency resource information of the Q reference signals, the Q reference signals sent by the network device, to obtain the receiving signals.

970: The Q terminal devices separately determine, based on their respective receiving signals, the configuration information of the Q reference signals, and the model parameters of the equivalent power amplifiers, model coefficients of equivalent power amplifiers of power amplifiers connected to their respective digital channels, where the receiving signals of the terminal devices are the Q reference signals received by the terminal devices, and the receiving signals received by the terminal devices are signals obtained from the Q reference signals amplified by the PAs connected to the digital channels.

Specifically, the terminal device determines the Q reference signals based on the configuration information of the Q reference signals. Specifically, the terminal device performs signal reconstruction based on the configuration information of the Q reference signals, to reconstruct the Q reference signals. The terminal device determines, based on the receiving signal, the Q reconstructed reference signals, and the model parameters of the equivalent power amplifiers, a model coefficient of an equivalent power amplifier of power amplifiers connected to a corresponding digital channel. Optionally, the terminal device may first process the receiving signal, for example, perform filtering or conversion from an analog signal into a digital signal, and then determine the model coefficient of the equivalent power amplifier of the corresponding digital channel.

In a frequency band of millimeter waves, a bandwidth of a reference signal may be up to 800 MHz, and the bandwidth of the reference signal occupies all of the channel bandwidth. After the reference signal passes through a PA, its spectrum may be expanded by three to five times. To improve accuracy of a determined model coefficient of an equivalent power amplifier, a terminal device needs to fully obtain out-of-band information of a post-PA signal or accurately set a width of a band-pass filter, to implement a band-limited nonlinear model estimation algorithm. Optionally, the first configuration information sent by the network device to the Q terminal devices may further indicate bandwidth information of the Q reference signals. Based on the bandwidth information of the reference signals, the terminal devices can fully obtain out-of-band information of post-PA signals or accurately set a width of a band-pass filter, to implement a band-limited nonlinear model estimation algorithm, thereby improving accuracy of the determined model coefficients of the equivalent power amplifiers.

980: The terminal device sends, to the network device, the model coefficient of the equivalent power amplifier of the power amplifiers connected to the corresponding digital channel. Specifically, the Q terminal devices respectively send, to the network device, the model coefficients of the equivalent power amplifiers of the power amplifiers connected to their respective digital channels.

For example, the terminal device may send the model coefficient of the equivalent power amplifier to the network device through RRC signaling or uplink control information (uplink control information, UCI).

990: The network device receives the model coefficients of the Q equivalent power amplifiers sent by the Q terminal devices. A model coefficient of an equivalent power amplifier sent by each terminal device is a model coefficient of an equivalent power amplifier of power amplifiers connected to a digital channel corresponding to a receiving signal of the terminal device.

Optionally, the network device determines, based on the model coefficients of the Q equivalent power amplifiers and the Q reference signals, digital predistortion coefficients respectively corresponding to the Q digital channels.

For example, the network device determines Q receiving signals of the Q terminal devices based on the model coefficients of the Q equivalent power amplifiers, the Q reference signals, and the model parameters of the equivalent power amplifiers, where the receiving signals are in a one-to-one correspondence with the terminal devices. Determining a receiving signal of a first terminal device in the Q terminal devices is used as an example. The network device determines a first receiving signal of the first terminal device based on a model coefficient of an equivalent power amplifier that is sent by the first terminal device, the Q reference signals, and the model parameters of the equivalent power amplifiers. Determining a receiving signal of a $q^{th}$ terminal device in the Q terminal devices is used as an example. The network device determines a $q^{th}$ receiving signal of the $q^{th}$ terminal device based on a model coefficient of an equivalent power amplifier that is sent by the $q^{th}$ terminal device, the Q reference signals, and the model parameters of the equivalent power amplifiers.

The network device determines, based on the Q receiving signals of the Q terminal devices and a $q^{th}$ reference signal in the Q reference signals, a digital predistortion coefficient corresponding to a $q^{th}$ digital channel in the Q digital channels, where the $q^{th}$ digital channel is a digital channel corresponding to the $q^{th}$ reference signal.

In the technical solution provided in this embodiment of this application, the network device sends the first configuration information and the second configuration information to the terminal devices; the terminal devices may reconstruct the Q reference signals of the Q digital channels of the network device based on the first configuration information; the terminal devices may determine and report the model coefficients of the equivalent power amplifiers of the Q digital channels of the network device based on the Q reference signals and the model parameters of the equivalent power amplifiers that are indicated by the second configuration information; and the network device may determine, based on the model coefficients of the equivalent power amplifiers connected to the Q digital channels, the digital predistortion coefficients corresponding to the Q digital channels. Compared with a solution in which a receiving signal of a terminal device is determined based on an output signal of each physical antenna and a channel response coefficient between each physical antenna and the terminal device, and then a digital predistortion coefficient corresponding to a digital channel is determined based on the receiving signal of the terminal device, this embodiment of this application can obviate the need to obtain an output signal of each physical antenna through wired feedback, thereby reducing costs. In addition, this embodiment of this application obviates the need to estimate the channel response coefficient between each physical antenna and the terminal device, thereby improving accuracy of the determined DPD coefficient.

A method for obtaining, by a network device, model coefficients of PAs connected to digital channels in an HBF FCS architecture is described below by using a specific example.

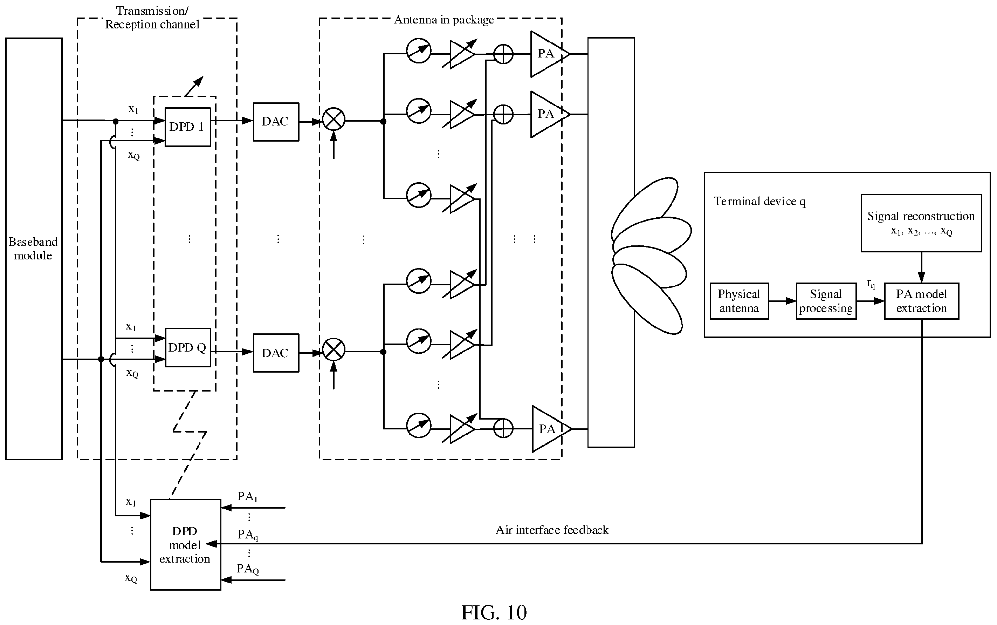

FIG. 10 is a diagram of obtaining DPD coefficients corresponding to digital channels in an HBF FCS architecture according to an embodiment of this application. Q digital channels of the network device correspond to Q terminal devices, *P* physical antennas correspond to *P* power amplifiers, each terminal device feeds back a model coefficient of an equivalent PA of a corresponding digital channel, and the physical antennas are connected to the power amplifiers in a one-to-one correspondence.

Taking a $q^{th}$ terminal device in the Q terminal devices as an example, the $q^{th}$ terminal device receives signals transmitted by *P* physical antennas of the network device, and the $q^{th}$ terminal device performs signal processing (processing) on the receiving signals that are received, to obtain $r_q$. The processing process includes processes such as channel estimation, equalization, and measurement signal combination. The channel estimation includes obtaining a channel response coefficient. The equalization includes removing impact of the channel response coefficient on the receiving signals. The measurement signal combination includes combining the receiving signals that are obtained at multiple times. The $q^{th}$ terminal device performs signal reconstruction (signal reconstruction), to reconstruct reference signals (reference signals, RSs) $x_1, x_2, ..., x_Q$ that are respectively sent through the Q digital channels. The $q^{th}$ terminal device performs model extraction (model extraction) based on $r_q$ and $x_1, x_2, ..., x_Q$, to determine a model coefficient of an equivalent power amplifier of power amplifiers connected to a $q^{th}$ digital channel, where the $q^{th}$ digital channel is a digital channel corresponding to the $q^{th}$ terminal device. The $q^{th}$ terminal device sends the determined model coefficient of the equivalent power amplifier to the network device. The network device determines, based on the model coefficient of the equivalent power amplifier sent by the $q^{th}$ terminal device, a DPD coefficient corresponding to the $q^{th}$ digital channel. That the $q^{th}$ terminal device performs model extraction based on $r_q$ and $x_1, x_2, ..., x_Q$ may be understood as that the $q^{th}$ terminal device performs model training based on $r_q$ and $x_1, x_2, ..., x_Q$, to obtain the model coefficient of the equivalent power amplifier of the power amplifiers connected to the $q^{th}$ digital channel.

A processing process of another terminal device in the Q terminal devices is similar to the processing process of the $q^{th}$ terminal device, and details are not described herein again.

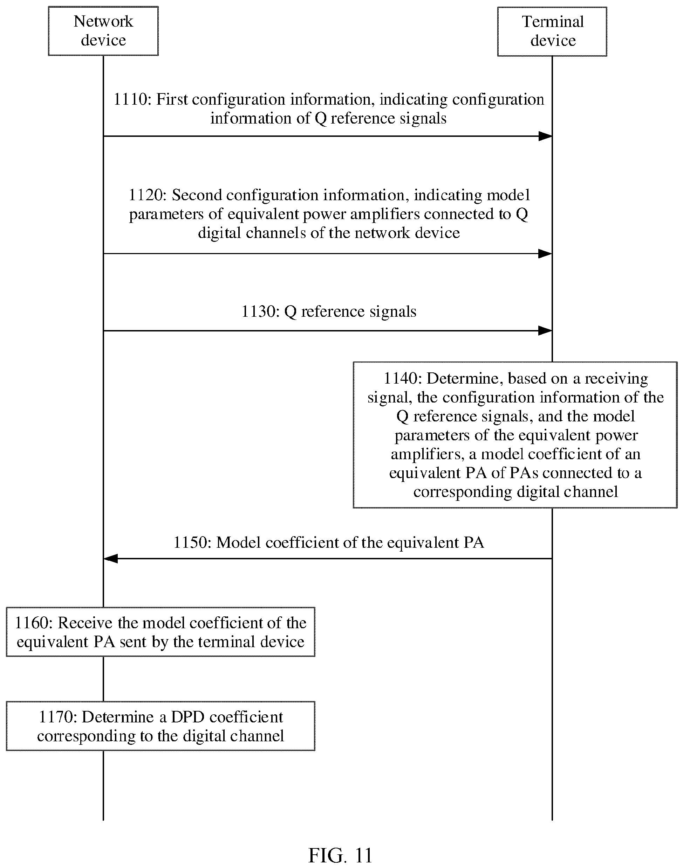

FIG. 11 is a schematic interaction flowchart of obtaining DPD coefficients corresponding to digital channels in an HBF FCS architecture according to an embodiment of this application.

1110: The network device sends first configuration information to the Q terminal devices, where the first configuration information indicates configuration information of Q reference signals. Correspondingly, the Q terminal devices receive the first configuration information sent by the network device.

For example, the configuration information of the Q reference signals includes type information of the Q reference signals, sequence information of the Q reference signals, time-frequency resource information of the Q reference signals, and antenna port information for sending the Q reference signals. One digital channel corresponds to one antenna port. The first configuration information may be used by the Q terminal devices to determine, through signal reconstruction, reference signals $x_1, x_2, ..., x_Q$ that are respectively sent through the Q digital channels of the network device.

A type of a reference signal includes a gold sequence type, a Zadoff-Chu (ZC) sequence type, or the like. The type of the reference signal may be represented by "seqN". Type information of the reference signal may indicate whether the reference signal is a single-carrier signal or a multicarrier signal. Sequence information of the reference signal indicates sequence parameter information for generating the reference signal. Each terminal device only needs to know antenna port information of a digital channel corresponding to the terminal device.

The Q reference signals are different reference signals. For example, types of the Q reference signals are different; or the types of the Q reference signals are the same, but sequence information of the Q reference signals is different. Because intermodulation interference exists between digital channel signals in a fully connected structure, reference signals sent through the digital channels should be different, to ensure non-singularity of a model matrix when the terminal device performs PA model training, thereby helping improve accuracy of the PA model training.

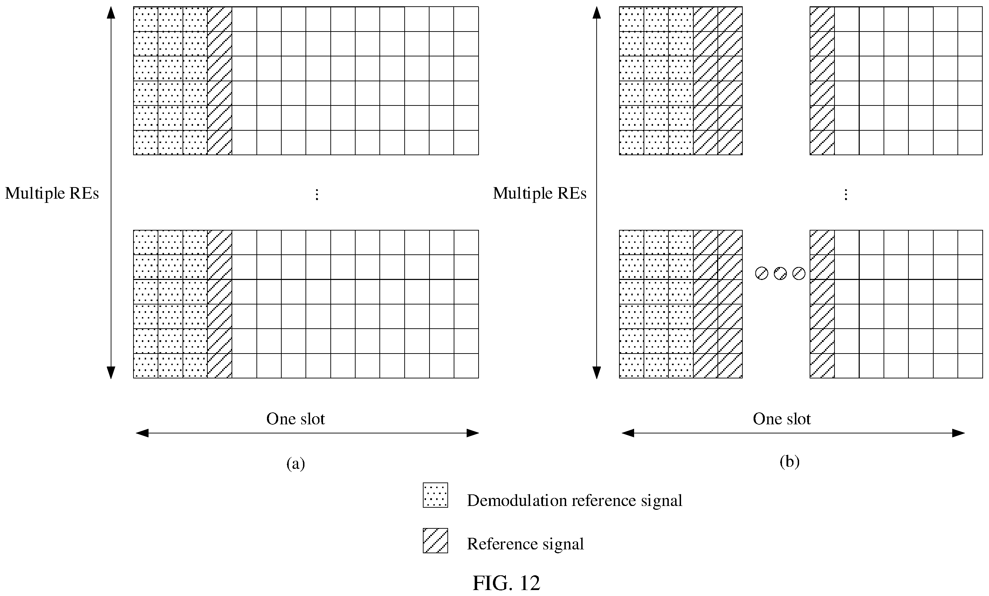

FIG. 12 is a diagram of a time-frequency structure of a reference signal according to an embodiment of this application. In (a) of FIG. 12, the reference signal occupies only one OFDM or DFT-s-OFDM symbol in time domain, and symbols preceding the reference signal may be used to send a signal such as a demodulation reference signal (demodulation reference signal, DMRS). In (b) of FIG. 12, the reference signal occupies a plurality of OFDM or DFT-s-OFDM symbols in time domain. Specifically, because a nonlinear effect of the PA is strongly correlated with a bandwidth of an input signal of the PA, the reference signal should occupy all of the channel bandwidth of a subsequent data transmission signal in frequency domain. A time domain length occupied by the reference signal may be considered as a trade-off between performance of training a PA model and training complexity.

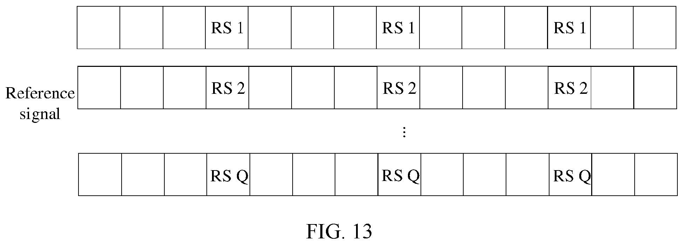

FIG. 13 is a diagram of periodically sending reference signals through different digital channels. The reference signal sent through each digital channel may be periodic. Different reference signals are sent through different digital channels. For example, an RS 1 is sent through a digital channel 1, an RS 2 is sent through a digital channel 2, and an RS Q is sent through a digital channel Q.

1120: The network device sends second configuration information to the Q terminal devices, where the second configuration information indicates model parameters of equivalent power amplifiers connected to the Q digital channels of the network device. Model parameters of all power amplifiers of the network device are the same, and model parameters of an equivalent power amplifier connected to each digital channel are the same as the model parameters of all the power amplifiers of the network device. Correspondingly, the Q terminal devices receive the second configuration information sent by the network device.

Optionally, the model parameters, indicated by the second configuration information, of the equivalent power amplifiers connected to the Q digital channels of the network device include at least one of a nonlinear order, a memory depth, a cross-term length, or a model type.

The model type of the PA indicated by the second configuration information may be any one of the FC-P model, the FC-MP model, and the FC-GMP model. Specifically, the network device may use modeltype1, modeltype2, or modeltype3 to indicate which fully connected model a terminal device uses to model the PA.

Taking the FC-MP model as an example, a receiving signal $r_q(n)$ received by the $q^{th}$ terminal device may be represented by the following formula (8):

$$r_q(n) = \sum_{m=0}^{M} \sum_{k=0}^{K} \sum_{k_1=0}^{k} \sum_{k_2=0}^{k-k_1} \cdots \sum_{k_{Q-1}=0}^{k-k_1-\cdots-k_Q} m_q(\mathrm{m}, \mathrm{k}, \cdots, \mathrm{k}_{Q-1}) \cdot x_q(n-m) \times |x_1(n-m)|^{k_1} \times$$

$$\cdots \times |x_{Q-1}(n-m)|^{k_{Q-1}} \times |x_Q(n-m)|^{k-k_1-\cdots-k_{Q-1}} \tag{8}$$

where $r_q(n)$ is obtained by superposing $x_1, x_2, ..., x_Q$ through a nonlinear combination; $n$ represents an instant; $K$ is a highest nonlinear order of the model; $M$ is a maximum memory depth of the model, and $m$ is a memory depth; $k$ is a nonlinear order; $m_q(\mathrm{m}, \mathrm{k}, \cdots, \mathrm{k}_{Q-1})$ is a model coefficient for a memory depth and a corresponding linear order; and $k_1, k_2, ..., k_Q$ are nonlinear orders of a model for PAs connected to each digital channel.

If the FC-P model is used, the PA has no memory, and an output signal $r_q(n)$ at an instant $n$ is only correlated with input signals $x_1(n), x_2(n), ..., x_Q(n)$ at the instant $n$. If the FC-GMP model is used, values of m in an absolute value term and a non-absolute value term on the right of the equal sign in formula (8) are different.

1130: The network device sends Q reference signals to the Q terminal devices through P physical antennas based on the time-frequency resource information of the Q reference signals in the first configuration information. The Q reference signals are simultaneously sent through the Q digital channels, and one reference signal is sent on each digital channel.

Correspondingly, the Q terminal devices receive, based on the time-frequency resource information of the Q reference signals, the Q reference signals sent by the network device, to obtain Q receiving signals. The Q receiving signals are in a one-to-one correspondence with the Q terminal devices.

1140: The Q terminal devices determine, based on their respective receiving signals, the configuration information of the Q reference signals, and the model parameters of the equivalent power amplifiers, model coefficients of equivalent PAs of PAs connected to their respective digital channels. The receiving signals of the terminal devices are the Q reference signals received by the terminal devices, and the receiving signals received by the terminal devices are signals obtained from the Q reference signals amplified by the PAs connected to the digital channels.

Specifically, a terminal device performs signal reconstruction based on the configuration information of the Q reference signals, to reconstruct pre-PA reference signals $x_1, x_2, ..., x_Q$ of the digital channels. The configuration information of the Q reference signals sent by the network device to the terminal device includes the type information of the Q reference signals, the sequence information of the Q reference signals, and the antenna port information for sending the Q reference signals. The terminal device may know a signal sequence of a reference signal of each digital channel based on the configuration information of the Q reference signals. The terminal device reconstructs the reference signals $x_1, x_2, ..., x_Q$ (pre-PA signals) of the digital channels by using steps such as "signal sequence - subcarrier mapping - inverse fast Fourier transform (inverse fast Fourier transform, IFFT) - upsampling". Specifically, an original signal sequence is placed at a corresponding frequency domain subcarrier position, converted into a time domain signal through IFFT, and then subjected to upsampling.

The terminal device processes a receiving signal, for example, performs filtering or conversion from an analog signal into a digital signal.

The terminal device performs model extraction, to obtain a model coefficient of an equivalent PA of PAs connected to a digital channel corresponding to the terminal device. The terminal device determines, based on the receiving signal that is received, the reconstructed reference signals $x_1, x_2, ..., x_Q$ of the digital channels, and the parameters of the PAs, the model coefficient of the equivalent PA of the PAs connected to the digital channel corresponding to the terminal device.

Taking the $q^{th}$ terminal device as an example, the reference signals $x_1, x_2, ..., x_Q$ reconstructed by the $q^{th}$ terminal device constitute a basis function matrix $X_q$, a column vector formed by the receiving signal $r_q$ of the $q^{th}$ terminal device is represented as $R_q$, and a to-be-estimated model coefficient of an equivalent PA is represented as $m^q$.

$m^q = [m_q(0,0,\cdots,0), m_q(0,0,\cdots,1), \cdots, m_q(M,K,\cdots,0)]^T$. $K$ is a highest nonlinear order of the model; $M$ is a maximum memory depth of the model; $m_q(0,0,\cdots,0)$ is a model coefficient of the equivalent PA when $m = 0, k = 0, \cdots, k_{Q-1} = 0$ in the corresponding formula (8); $m_q(0,0,\cdots,1)$ is a model coefficient of the equivalent PA when $m = 0$, $k = 0$, $\cdots$, $k_{Q-1} = 1$ in the corresponding formula (8); and $m_q(M,K,\cdots,0)$ is a model coefficient of the equivalent PA when $m = M$, $k = K$, $\cdots$, $k_{Q-1} = 0$ in the corresponding formula (8).

The model coefficient of the equivalent PA may be determined by using a least squares algorithm, and a specific calculation formula is formula (9) as follows:

$$m^q = \arg\min{}_{m^q} \left\| R_q - X_q m^q \right\|_2^2 = \left( X_q^{\mathrm{H}} X_q \right)^{-1} X_q^{\mathrm{H}} R_q \qquad (9)$$

where $\arg\min{}_{m^q}$ represents a corresponding $m^q$ when the formula has a minimum value, and H represents a conjugate transpose.

Optionally, the terminal device may determine the model coefficient of the equivalent PA by using a least mean squares (least mean squares, LMS) or recursive least squares (recursive least squares, RLS) algorithm. This is not limited in embodiments of this application.

Optionally, the first configuration information sent by the network device to the terminal devices may further indicate bandwidth information of the Q reference signals. Based on the bandwidth information of the reference signals, the terminal devices can fully obtain out-of-band information of post-PA signals or accurately set a width of a band-pass filter, to implement a band-limited nonlinear model estimation algorithm, thereby improving accuracy of the determined model coefficients of the equivalent power amplifiers.

In an implementation, the network device and the terminal devices may agree on the bandwidth information of the reference signals, with a possible value being $30.72e^6 \times [1,2,4,8,16,32,64]$sps. Specifically, the network device may use a "modelBandwidth" field to indicate the bandwidth of the reference signals.

1150: After determining the model coefficients of the equivalent PAs of the PAs connected to the corresponding digital channels, the terminal devices send the model coefficients of the equivalent PAs to the network device. Specifically, the Q terminal devices respectively send, to the network device, the model coefficients of the equivalent PAs of the PAs connected to their respective digital channels. For example, a model coefficient of an equivalent PA that is sent by a first terminal device is $m^1$, a model coefficient of an equivalent PA that is sent by a second terminal device is $m^2$, a model coefficient of an equivalent PA that is sent by the $q^{th}$ terminal device is $m^q$, and a model coefficient of an equivalent PA that is sent by a Q$^{th}$ terminal device is $m^Q$.

For example, the terminal devices may send the model coefficients of the equivalent PAs to the network device through RRC signaling or UCI.

1160: The network device receives the model coefficients of the Q equivalent PAs sent by the Q terminal devices. One terminal device sends a model coefficient of one equivalent PA, where the model coefficient of the equivalent PA is a model coefficient of an equivalent PA of PAs connected to a digital channel corresponding to the terminal device.

1170: After receiving the model coefficients $m^1, m^2 \cdots m^Q$ of the equivalent PAs fed back by the Q terminal devices, the network device determines receiving signals of the Q terminal devices based on the model coefficients of the Q equivalent PAs and the Q reference signals, and then determines, based on the receiving signals of the Q terminal devices, DPD coefficients corresponding to the Q digital channels. A specific determining process is as follows:

(1) The network device determines $r_1, r_2, ..., r_Q$ through the foregoing formula (8) based on the model coefficients of the Q equivalent PAs, the reference signals $x_1, x_2, ..., x_Q$, and the model parameters of the equivalent power amplifiers indicated by the second configuration information.

(2) The network device determines, by using the LS algorithm through the following formula (10), DPD coefficients $c_1$, $c_2, ..., c_Q$ corresponding to the digital channels:

$$C_q = \arg\min{}_{C_q} \left\| X_q - R_q C_q \right\|_2^2 = \left( R_q^H R_q \right)^{-1} R_q^H X_q \qquad (10)$$

where $c_q$ represents a DPD coefficient of a $q^{th}$ digital channel.

For example, the network device may determine, based on the Q receiving signals sent by the Q terminal devices and a reference signal $x_1$ sent on a first digital channel, a DPD coefficient $c_1$ corresponding to the first digital channel.

In this embodiment, in the HBF FCS architecture, the terminal devices assist in obtaining the model coefficients of the equivalent PAs of the PAs connected to the digital channels, and the network device may determine the receiving signals of the terminal devices based on the Q reference signals and the model coefficients of the equivalent PAs. The network device does not need to obtain an output signal of each physical antenna through wired feedback, or need to estimate a channel response coefficient between a physical antenna and a terminal device, thereby reducing implementation costs of obtaining the DPD coefficients, and improving accuracy of the obtained DPD coefficients.

An embodiment of this application provides another information measurement method. In the method, a terminal device may assist in obtaining a model coefficient of an equivalent PA of PAs connected to each digital channel of a network device, and the network device may determine, based on the model coefficient of the equivalent PA of the PAs connected to the digital channel that is reported by the terminal device, a DPD coefficient corresponding to the digital channel. The accuracy of determining the DPD coefficient can be improved.

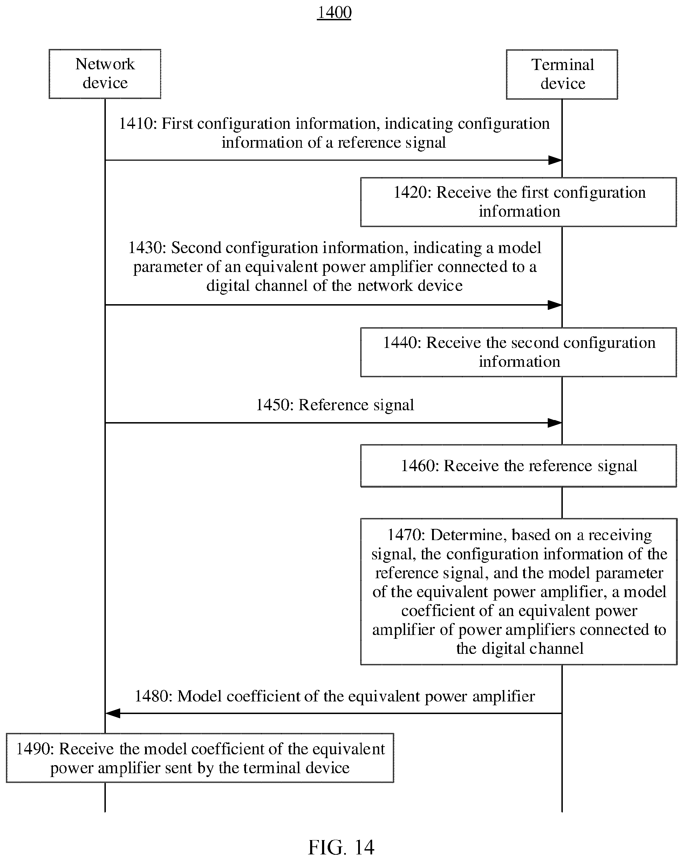

FIG. 14 is a schematic interaction flowchart of an information measurement method 1400 according to an embodiment of this application. The method may be used in an HBF architecture and also a DBF architecture. The network device includes Q digital channels. Q terminal devices may be used to assist in obtaining DPD coefficients respectively corresponding to the Q digital channels, or one of Q terminal device may be used to assist in obtaining DPD coefficients respectively corresponding to the Q digital channels, or S terminal devices may be used to assist in obtaining DPD coefficients respectively corresponding to the Q digital channels. This is not specifically limited in this embodiment of this application. Q is an integer greater than 1, and S is an integer greater than 1 and less than Q. In this embodiment, the network device sends a reference signal in a time-division manner, to obtain DPD coefficients respectively corresponding to the Q digital channels. When a signal is transmitted through one digital channel, other digital channels are disabled.

1410: The network device sends first configuration information to the terminal device, where the first configuration information indicates configuration information of a reference signal. Optionally, the first configuration information may be sent by the network device to the terminal device through radio resource control (radio resource control, RRC) signaling.

Optionally, the first configuration information includes one or more of the following: type information of the reference signal, sequence information of the reference signal, time-frequency resource information of the reference signal, or antenna port information for sending the reference signal, where the time-frequency resource information corresponds to the antenna port information.

For example, the time-frequency resource information of the reference signal includes a time domain frequency resource and a frequency domain resource that are used to carry the reference signal. Specifically, the time domain resource includes a transmission time, a transmission periodicity, a slot offset of the transmission time, and a quantity of time domain symbols occupied by the transmission time. Time-frequency resources used to carry different reference signals correspond to different antenna ports, and antenna port information may be reflected by the time-frequency resources of the reference signals.

If the network device uses one terminal device to assist in obtaining the DPD coefficients respectively corresponding to the Q digital channels, the network device sends configuration information of Q reference signals to the terminal device through the first configuration information. The Q reference signals may be the same reference signal, or may be different reference signals. In a PCS architecture, pre-PA signals of different digital channels do not interfere with each other, and a signal output by an equivalent power amplifier of power amplifiers connected to each digital channel is a nonlinear combination of pre-PA signals of the digital channel, and is independent of other digital channels.

If the network device uses Q terminal devices to assist in obtaining the DPD coefficients respectively corresponding to the Q digital channels, with each digital channel corresponding to one terminal device, the network device sends configuration information of only one reference signal to the terminal device through the first configuration information.

1420: Correspondingly, the terminal device receives the first configuration information sent by the network device. The terminal device may reconstruct a reference signal of a corresponding digital channel based on the first configuration information. A reference signal of a digital channel may be referred to as an original signal of the digital channel or a signal prior to amplification by a power amplifier.

1430: The network device sends second configuration information to the terminal device, where the second configuration information indicates a model parameter of an equivalent power amplifier connected to a digital channel of the network device. Model parameters of equivalent power amplifiers connected to different digital channels of the network device may be the same or different. When the network device uses one terminal device to assist in obtaining the DPD coefficients respectively corresponding to the Q digital channels, the second configuration information sent by the network device to the terminal device indicates model parameters of equivalent power amplifiers connected to the Q digital channels. When the network device uses Q terminal devices to assist in obtaining the DPD coefficients respectively corresponding to the Q digital channels, the network device sends the second configuration information to each of the Q terminal devices. The second configuration information received by each terminal device indicates a model parameter of an equivalent power amplifier connected to a digital channel corresponding to (measured by) the terminal device.

Optionally, the model parameter, indicated by the second configuration information, of the equivalent power amplifier connected to the digital channel of the network device includes at least one of a nonlinear order, a memory depth, a cross-term length, or a model type. The model type may be any one or more of a P model, an MP model, and a GMP model. If the model type of a digital channel is the P model, the model parameter indicated by the second configuration information further includes a nonlinear order, that is, $M = G = 0$. If the model type of a digital channel is the MP model, the model parameter indicated by the second configuration information further includes a nonlinear order and a memory depth, that is, $G = 0$. If the model type of a digital channel is the GMP model, the model parameter indicated by the second configuration information further includes a nonlinear order, a memory depth, and a cross-term length.

Optionally, each of power amplifiers is connected to one digital channel of the network device. It may be understood that each digital channel is connected to all physical antennas of only one subarray. This embodiment may be applied to the HBF PCS architecture.

The second configuration information may be sent by the network device to the terminal device through RRC signaling. The first configuration information and the second configuration information may be sent to the terminal device through the same RRC signaling, or may be sent to the terminal device through different RRC signaling.

1440: The terminal device receives the second configuration information sent by the network device.

1450: The network device sends the reference signal to the terminal device through at least one physical antenna corresponding to the digital channel. For example, the network device sends, based on the time-frequency resource information of the reference signal, the reference signal to the terminal device through the at least one physical antenna corresponding to the digital channel. A power amplifier is connected to a physical antenna in a one-to-one correspondence.

1460: The terminal device receives the reference signal sent by the network device, to obtain a receiving signal. For example, the terminal device receives, based on the time-frequency resource information of the reference signal, the reference signal sent by the network device, to obtain the receiving signal.

For example, the terminal device receives, based on time-frequency resource information of a first reference signal, the first reference signal sent by the network device through a first digital channel. In this case, the receiving signal received by the terminal device is a signal obtained from the first reference signal amplified by PAs connected to the first digital channel through which the first reference signal is sent.

1470: The terminal device determines, based on the receiving signal that is received, the configuration information of the reference signal, and the model parameter of the equivalent power amplifier connected to the digital channel, a model coefficient of an equivalent power amplifier of power amplifiers connected to the digital channel. For example, the terminal device receives, on a time-frequency resource of the first reference signal, the first reference signal sent by the network device through the first digital channel; and the terminal device determines a model coefficient of an equivalent power amplifier of the first digital channel based on the receiving signal received on the time-frequency resource of the first reference signal, the configuration information of the first reference signal, and the model parameter of the equivalent power amplifier connected to the first digital channel.

Specifically, the terminal device determines the reference signal based on the configuration information of the reference signal. Specifically, the terminal device performs signal reconstruction based on the configuration information of the reference signal, to reconstruct the reference signal. The terminal device determines, based on the receiving signal, the reconstructed reference signal, and the model parameter of the equivalent power amplifier, a model coefficient of an equivalent power amplifier of power amplifiers connected to a corresponding digital channel. Optionally, the terminal device may first process the receiving signal, for example, perform filtering or conversion from an analog signal into a digital signal, and then determine the model coefficient of the equivalent power amplifier of the corresponding digital channel.

Optionally, the first configuration information sent by the network device to the terminal device further indicates bandwidth information of the reference signal. Based on the bandwidth information of the reference signal, the terminal device can fully obtain out-of-band information of a post-PA signal, or accurately set a width of a band-pass filter, to implement a band-limited nonlinear model estimation algorithm, thereby improving accuracy of the determined model coefficient of the equivalent power amplifier.

1480: The terminal device sends, to the network device, the model coefficient of the equivalent power amplifier of the power amplifiers connected to the corresponding digital channel.

For example, the terminal device may send, to the network device through RRC signaling or UCI, model coefficients of equivalent power amplifiers of power amplifiers connected to different digital channels.

1490: The network device receives the model coefficient, sent by the terminal device, of the equivalent power amplifier of the power amplifiers connected to the digital channel. When the network device uses Q terminal devices to assist in obtaining the DPD coefficients respectively corresponding to the Q digital channels, the Q terminal devices respectively send, to the network device, model coefficients of equivalent power amplifiers of power amplifiers connected to their respective digital channels. The network device receives the model coefficients of the equivalent power amplifiers respectively sent by the Q terminal devices, where one terminal device sends a model coefficient of an equivalent power amplifier connected to one digital channel. When the network device uses one terminal device to assist in obtaining the DPD coefficients respectively corresponding to the Q digital channels, the terminal device sends, to the network device, model coefficients of equivalent power amplifiers of power amplifiers connected to the Q digital channels. The network device receives the model coefficients, sent by the terminal device, of the equivalent power amplifiers connected to the Q digital channels.

Optionally, the network device determines, based on the model coefficient of the equivalent power amplifier and the reference signal, a digital predistortion coefficient corresponding to the digital channel.

For example, the network device determines the receiving signal of the terminal device based on the model coefficient of the equivalent power amplifier connected to the digital channel, the reference signal of the digital channel, and the model parameter of the equivalent power amplifier connected to the digital channel. The network device may determine, based on the receiving signal of the terminal device and the reference signal of the digital channel, the digital predistortion coefficient corresponding to the digital channel by using a direct learning structure or an indirect learning structure.

In the technical solution provided in this embodiment of this application, the network device sends the first configuration information and the second configuration information to the terminal device; the terminal device may reconstruct the reference signal of the digital channel of the network device based on the first configuration information; the terminal device may determine and report the model coefficient of the equivalent power amplifier connected to the digital channel based on the reference signal and the model parameter of the equivalent power amplifier of the digital channel that is indicated by the second configuration information; and the network device may determine, based on the model coefficient of the equivalent power amplifier of the digital channel, the digital predistortion coefficient corresponding to the digital channel by using a direct learning structure or an indirect learning structure. Compared with a solution in which a remote device measures and directly feeds back a DPD coefficient, this embodiment of this application allows the network device to flexibly determine, based on a model coefficient of an equivalent power amplifier of a digital channel that is fed back by the remote device, a digital predistortion coefficient corresponding to the digital channel, and the terminal device is not able to know an algorithm used by the network device to determine the DPD coefficient.

A method for obtaining, by a network device, model coefficients of PAs connected to digital channels in an HBF FCS architecture is described below by using a specific example. In the HBF PCS architecture, all PAs connected to the same digital channel may be equated to one equivalent PA. The terminal device may feed back model coefficients of equivalent PAs of all the digital channels one by one, so that the network device can quickly obtain a DPD coefficient of each digital channel.

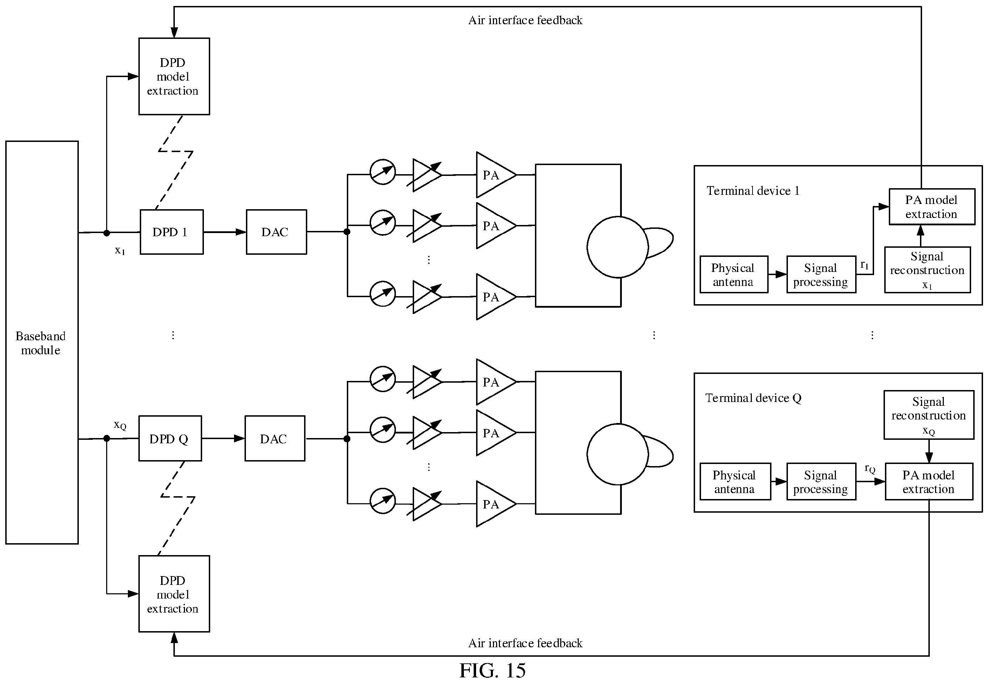

FIG. 15 is a diagram of obtaining DPD coefficients corresponding to digital channels in an HBF PCS architecture according to an embodiment of this application. Different digital channels may be referred to as different polarization directions. To avoid mutual interference between different digital channels/polarization directions, when a signal is transmitted through one digital channel, other digital channels are disabled; that is, a reference signal is sent in a time-division manner. Q digital channels of a network device may correspond to Q terminal devices. Alternatively, the Q digital channels of the network device may correspond to one terminal device. When the Q digital channels of the network device correspond to Q terminal devices, each terminal device feeds back a model coefficient of an equivalent PA of PAs connected to a corresponding digital channel. When the Q digital channels of the network device correspond to one terminal device, the terminal device feeds back model coefficients of equivalent PAs of PAs connected to the Q digital channels. Finally, the network device calculates and applies the DPD coefficients of all the digital channels.

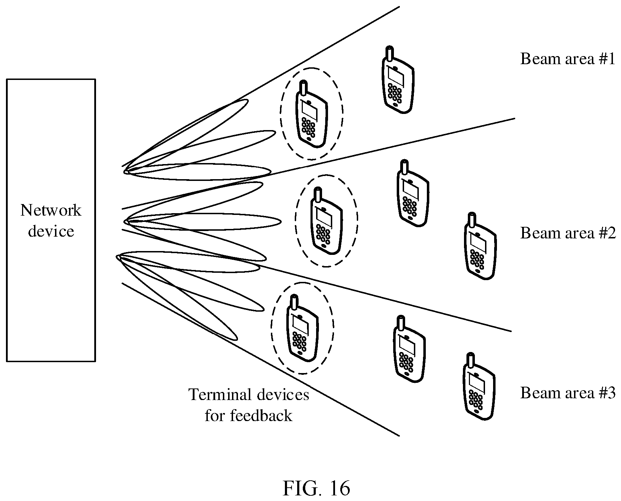

When the network device has a relatively large coverage, the network device may search for a plurality of terminal devices in different beam areas, and the plurality of terminal devices complete feedback of model coefficients of equivalent PAs connected to the corresponding digital channels. FIG. 16 is a diagram of performing, by terminal devices, feedback of model coefficients of equivalent PAs in different beam areas according to an embodiment of this application.

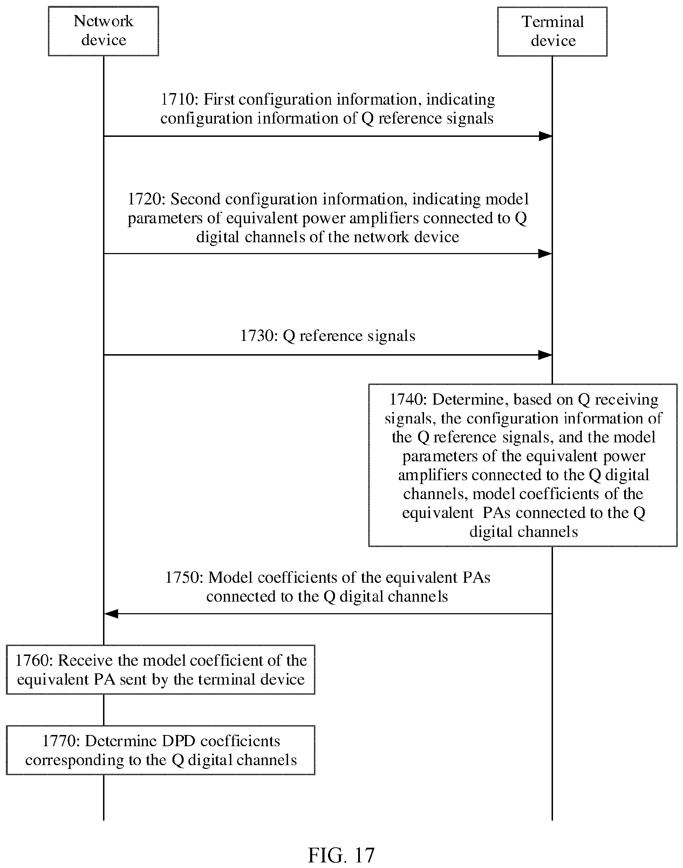

FIG. 17 is a schematic interaction flowchart of obtaining DPD coefficients connected to digital channels in an HBF PCS architecture according to an embodiment of this application. In this example, one terminal device assists the network device in obtaining the model coefficients of the equivalent PAs connected to the Q digital channels.

1710: The network device sends first configuration information to the terminal device, where the first configuration information indicates configuration information of Q reference signals. The Q reference signals are sent through the Q digital channels, and one reference signal is sent on each digital channel. Correspondingly, the terminal device receives the first configuration information sent by the network device.

For example, the configuration information of the Q reference signals includes type information of the Q reference signals, sequence information of the Q reference signals, time-frequency resource information of the Q reference signals, and antenna port information for sending the Q reference signals. One digital channel corresponds to one antenna port. The network device sends the configuration information of the Q reference signals to the terminal device, so that the terminal device determines, through signal reconstruction, reference signals $x_1$, $x_2$, ..., $x_Q$ that are respectively sent through the Q digital channels of the network device.

A type of a reference signal may be a gold sequence type, or a ZC sequence type, or another sequence type.

In the HBF PCS architecture, pre-PA signals of different digital channels do not interfere with each other, and a signal output by an equivalent PA of PAs connected to each digital channel is a nonlinear combination of pre-PA signals of the digital channel, and is independent of other digital channels. Therefore, the Q reference signals may be the same Q reference signals, or different Q reference signals. It may be understood that the Q reference signals may be of the same type or the same sequence, or the Q reference signals may be of different types or different sequences.

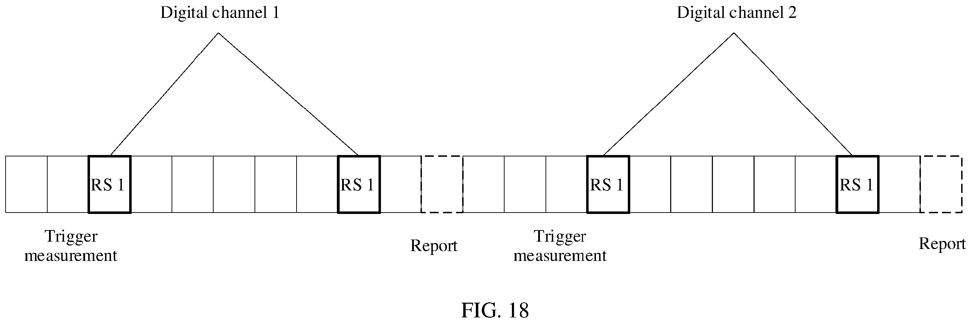

FIG. 18 is a diagram of sending the same reference signal through different digital channels according to an embodiment of this application. An RS 1 represents a reference signal sent by the network device. The first two RSs 1 are reference signals sent on a digital channel 1/polarization direction 1, and the last two RSs 1 are reference signals sent on a digital channel 2/polarization direction 2. A plurality of reference signals that are sent by the network device and that correspond to the same digital channel cannot be staggered. In other words, the plurality of reference signals of the digital channel 2 are sent only after the plurality of reference signals of the digital channel 1 are sent. The terminal device sequentially receives the RSs 1 sent by the network device. After receiving the RSs 1 sent on the digital channel 1, the terminal device determines a model coefficient of an equivalent PA of PAs connected to the digital channel 1, and reports the model coefficient to the network device. After receiving the RSs 1 sent on the digital channel 2, the terminal device determines a model coefficient of an equivalent PA of PAs connected to the digital channel 2, and reports the model coefficient to the network device.

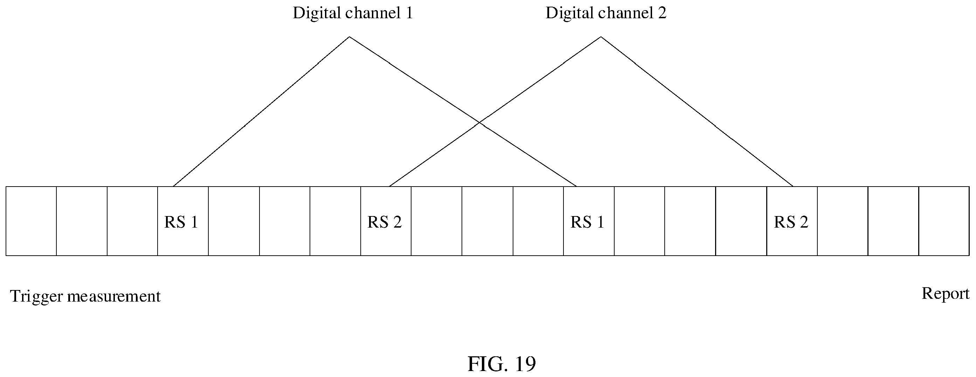

FIG. 19 is another diagram of sending different reference signals through different digital channels according to an embodiment of this application. An RS 1 is a reference signal sent on a digital channel 1/polarization direction 1, and an RS 2 is a reference signal sent on a digital channel 2/polarization direction 2. Because time-frequency resources corresponding to the two reference signals are different, the terminal device can identify and detect post-PA signals on different digital channels. Therefore, a plurality of reference signals that are sent by the network device and that correspond to the same digital channel can be staggered, without affecting accuracy of a model coefficient of an equivalent PA that is determined by the terminal device. After receiving RSs 1 sent on the digital channel 1, the terminal device determines a model coefficient of an equivalent PA of PAs connected to the digital channel 1. After receiving RSs 2 sent on the digital channel 2, the terminal device determines a model coefficient of an equivalent PA of PAs connected to the digital channel 2. The terminal device may report, to the network device, the model coefficient of the equivalent PA of the PAs connected to the digital channel 1 together with the model coefficient of the equivalent PA of the PAs connected to the digital channel 2.

For example, the time-frequency resource information of the reference signal includes a time domain resource and a frequency domain resource that are used to carry the reference signal. Specifically, the time domain resource includes a transmission time, a transmission periodicity, a slot offset of the transmission time, and a quantity of time domain symbols occupied by the transmission time. Time-frequency resources used to carry different reference signals correspond to different antenna ports, and antenna port information may be reflected by the time-frequency resources of the reference signals.

1720: The network device sends second configuration information to the terminal device, where the second configuration information indicates model parameters of power amplifiers connected to the Q digital channels of the network device. Model parameters of equivalent power amplifiers connected to different digital channels of the network device may be the same or different. Specifically, the network device may indicate a model parameter of an equivalent PA connected to each digital channel. Correspondingly, the terminal device receives the second configuration information sent by the network device.

The model parameter indicated by the second configuration information includes at least one of a nonlinear order, a memory depth, a cross-term length, or a model type. The model type of the PA indicated by the second configuration information may be any one or more of a P model, an MP model, and a GMP model.

If the model type of a digital channel is the P model, the model parameter indicated by the second configuration information further includes a nonlinear order, that is, $M = G = 0$. If the model type of a digital channel is the MP model, the model parameter indicated by the second configuration information further includes a nonlinear order and a memory depth, that is, $G = 0$. If the model type of a digital channel is the GMP model, the model parameter indicated by the second configuration information further includes a nonlinear order, a memory depth, and a cross-term length.

1730: The network device separately sends the Q reference signals to the terminal device based on the time-frequency resource information of the Q reference signals. For example, the network device sends a first reference signal to the terminal device on a time-frequency resource of the first reference signal. After sending the first reference signal, the network device sends a second reference signal to the terminal device on a time-frequency resource of the second reference signal. The Q reference signals include a first reference signal and a second reference signal.

Correspondingly, the terminal device separately receives, based on the time-frequency resource information of the Q reference signals, the Q reference signals sent by the network device. For example, the terminal device receives, on the time-frequency resource of the first reference signal, the first reference signal sent by the network device through a first digital channel. In this case, the receiving signal received by the terminal device is a signal obtained from the first reference signal amplified by PAs connected to the first digital channel through which the first reference signal is sent. The terminal device receives, on the time-frequency resource of the second reference signal, the second reference signal sent by the network device through a second digital channel. In this case, the receiving signal received by the terminal device is a signal obtained from the second reference signal amplified by PAs connected to the second digital channel through which the second reference signal is sent.

1740: The terminal device determines, based on receiving signals received on different time-frequency resources, the configuration information of the Q reference signals, and the model parameters of the equivalent power amplifiers connected to the Q digital channels, model coefficients of equivalent PAs of PAs connected to different digital channels.

For example, the terminal device receives, on the time-frequency resource of the first reference signal, the first reference signal sent by the network device through the first digital channel; and the terminal device determines, based on the receiving signal received on the time-frequency resource of the first reference signal, the configuration information of the first reference signal, and the model parameter of the equivalent PA connected to the first digital channel, a model coefficient of an equivalent PA of PAs connected to the first digital channel. Specifically, the terminal device performs signal reconstruction based on the configuration information of the first reference signal, to reconstruct a pre-PA reference signal $x_1$ of the first digital channel. The terminal device processes the receiving signal received on the time-frequency resource of the first reference signal, for example, performs filtering or conversion from an analog signal into a digital signal. The terminal device performs model extraction, to obtain the model coefficient of the equivalent PA of the PAs connected to the first digital channel.

Taking the MP model as an example, the reference signal sent on the digital channel and the receiving signal received by the terminal device may be represented by the following formula (11):

$$r(\mathrm{n}) = \sum_{k=1}^{K} \sum_{m=0}^{M-1} b_{km} \left| x(n-m) \right|^{k-1} x(n-m) \qquad (11)$$

where $K$ is a highest nonlinear order of the model; $M$ is a maximum memory depth of the model; $b_{km}$ is a model coefficient of an equivalent PA; $m$ is a memory depth; and $k$ is a nonlinear order.

The reference signal of the digital channel that is reconstructed by the terminal device may be represented as $X$, the receiving signal (a post-PA signal) received by the terminal device forms a column vector $R$, the to-be-estimated model coefficient of the equivalent PA is represented as b. The model coefficient of the equivalent PA of the PAs connected to the digital channel is determined by using a least squares algorithm. A specific calculation formula is formula (12) as follows:

$$\mathrm{b} = \arg\min_b \left\| R - Xb \right\|_2^2 = \left( X^{\mathrm{H}} X \right)^{-1} X^{\mathrm{H}} R \qquad (12)$$

where $\arg\min_b$ represents a corresponding b when the formula has a minimum value, and H represents a conjugate transpose. b is a column vector formed by model coefficients of equivalent PAs, $b=[b_{1,0},b_{2,0},\cdots,b_{K,M-1}]^{\mathrm{T}}$ ; $X$ is an N-dimensional basis function matrix of pre-PA signals, N represents a quantity of data sampling points of pre-PA signals and post-PA signals, and $X=[\phi_{10}(x),\phi_{20}(x),\cdots,\phi_{K(M-1)}(x)]$; $R$ is an N-dimensional basis function matrix of post-PA signals, and $R=[r(n),r(n+1),\cdots,r(n+N-1)]^{\mathrm{T}}$ ; and a basis function is

$$\phi_{km}(\mathrm{x}) = [\left| x(n-m) \right|^{k-1} x(n-m), \left| x(n+1-m) \right|^{k-1} x(n+1-m), \cdots, \left| x(n+N-1-m) \right|^{k-1}$$

$$x(n+N-1-m)] \, .$$

Optionally, the first configuration information sent by the network device to the terminal device further indicates bandwidth information of the Q reference signals. In this way, the terminal device can fully obtain out-of-band information of a post-PA signal, or accurately set a width of a band-pass filter, to implement a band-limited nonlinear model estimation algorithm, thereby improving accuracy of the determined model coefficient of the equivalent power amplifier.

1750: After determining the model coefficients of the equivalent PAs of the PAs connected to the Q digital channels, the terminal device sends, to the network device, the model coefficients of the equivalent PAs of the PAs connected to the Q digital channels.

For example, the terminal devices may send the model coefficients of the equivalent PAs to the network device through RRC signaling or UCI.

Table 1 shows a reporting format of a model coefficient of an equivalent PA. Model coefficients of equivalent PAs of the same memory depth are in the same column, and model coefficients of equivalent PAs of the same nonlinear order are in the same row.

Table 1

| | | | |
|---|---|---|---|
| $b_{1,0}$ | $b_{1,1}$ | $b_{1,2}$ | ... |
| $b_{2,0}$ | $b_{2,1}$ | $b_{2,2}$ | ... |
| $b_{3,0}$ | $b_{3,1}$ | $b_{3,2}$ | ... |

(continued)

| ... | ... | ... | ... |
|-----|-----|-----|-----|

Optionally, the terminal device may feed back only model coefficients of equivalent PAs whose nonlinear orders are odd numbers. Table 2 shows model coefficients of equivalent PAs whose nonlinear orders are odd numbers. The PA model may also be well fitted by using the model coefficients of the equivalent PAs whose value of $k$ is an odd number, which helps reduce overheads caused by model coefficient feedback.

Table 2

| $b_{1,0}$ | $b_{1,1}$ | $b_{1,2}$ | ... |
|-----------|-----------|-----------|-----|
| $b_{3,0}$ | $b_{3,1}$ | $b_{3,2}$ | ... |
| ... | ... | ... | ... |

1760: The network device receives the model coefficients, sent by the terminal device, of the equivalent PAs of the PAs connected to the Q digital channels.

1770: After receiving the model coefficients of the equivalent PAs of the PAs connected to the Q digital channels, the network device determines the DPD coefficients corresponding to the Q digital channels. The network device may determine, by using a direct learning structure or an indirect learning structure, the DPD coefficients corresponding to the digital channels.

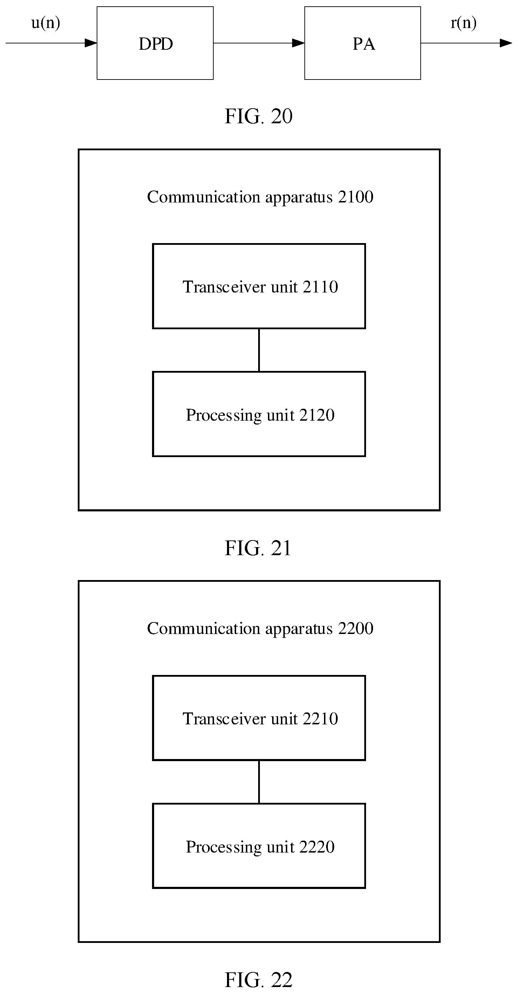

The direct learning structure minimizes an error $e(n)$ between an output signal $r(n)$ of a PA and an input signal $u(n)$ of a DPD model. The output signal of the PA is linearly correlated with the input signal of the DPD model. FIG. 20 is a diagram illustrating that an input signal $u(n)$ passes through a DPD module and a PA. A relationship between $r(n)$ and $u(n)$ may be represented by the following formula (13) and formula (14):

$$e(\text{n}) = r(n)/G - u(n) \qquad (13)$$

where G represents a multiple of a PA amplification gain.

$$\text{r=f}\left[U\alpha\right] \qquad (14)$$

where $U$ represents a kernel matrix formed by $u(n)$, f[ ] represents a known PA nonlinear function, and $\alpha$ represents a to-be-estimated DPD coefficient.

If the network device determines the DPD coefficient by using the direct learning structure, the determined DPD coefficient may be represented by the following formula (15):

$$\text{J} = \left\|\text{e}\right\|^2 = \left\|\text{r}/G - \text{u}\right\|^2 \qquad (15)$$

where a value of $\alpha$ is the determined DPD coefficient when a value of J is minimum.

The indirect learning structure is a theory of equating a pre-inverse model of a PA to a post-inverse model of the PA, and a DPD coefficient is directly calculated based on an input signal and an output signal of an equivalent PA, for use by a predistortion module. A specific determining process is as follows:

(1) The network device determines a receiving signal (equivalent to a post-PA signal) $[r(n), r(n+1), \cdots, r(n+N\text{-}1)]$ of the terminal device based on a model coefficient of an equivalent PA of APs connected to a digital channel, a reference signal (a pre-PA signal) $[x(n), x(n+1), \cdots, x(n+N\text{-}1)]$ of the digital channel, and formula (11).

(2) According to the theoretical knowledge, a pre-inverse model of a PA is equated to a post-inverse model of the PA. If positions of the input signal and the output signal of the PA model are interchanged, the DPD model may be written as the following formula (16):

$$x(\text{n}) = \sum_{k=1}^{K} \sum_{m=0}^{M-1} b_{km} \left| r(n-m) \right|^{k-1} r(n-m) \qquad (16)$$

(3) The network device determines, by using the LS algorithm through the following formula (17), the DPD coefficients corresponding to the digital channels:

$$C_q = \arg\min_{C_q} \left\| X - RC_q \right\|_2^2 = \left( R^H R \right)^{-1} R^H X \qquad (17)$$

where $c_q$ represents a DPD coefficient of a $q^{th}$ digital channel.

The network device performs predistortion processing on a reference signal of a corresponding digital channel based on the determined DPD coefficient of the digital channel. Optionally, if the terminal device feeds back a model coefficient of an equivalent PA in a band-limited model, the network device can also obtain the DPD coefficient through the foregoing steps. The model coefficient of the equivalent PA in the band-limited model may be understood as a model coefficient of the equivalent PA that is determined after the terminal device performs filtering on the receiving signal by using a band-pass filter.

The foregoing describes the information measurement methods provided in embodiments of this application. The following describes entities for performing the foregoing information measurement methods.

An embodiment of this application provides a communication apparatus. FIG. 21 is a diagram of a structure of a communication apparatus 2100 according to an embodiment of this application. The apparatus 2100 may be used or deployed in the terminal device in the method embodiments in FIG. 9 and FIG. 11. The communication apparatus 2100 includes a transceiver unit 2110 and a processing unit 2120.

The transceiver unit 2110 is configured to receive first configuration information sent by a network device, where the first configuration information indicates configuration information of Q reference signals, and Q is an integer greater than 1.

The transceiver unit 2110 is further configured to receive second configuration information sent by the network device, where the second configuration information indicates model parameters of equivalent power amplifiers connected to Q digital channels of the network device.

The transceiver unit 2110 is further configured to receive the Q reference signals sent by the network device, to obtain a receiving signal.

The processing unit 2120 is configured to determine a model coefficient of an equivalent power amplifier based on the receiving signal, the configuration information of the Q reference signals, and the model parameters of the equivalent power amplifiers, where the equivalent power amplifier is an equivalent power amplifier of power amplifiers connected to the digital channel corresponding to the receiving signal.

The transceiver unit 2110 is further configured to send the model coefficient of the equivalent power amplifier to the network device.

Optionally, the processing unit 2120 is specifically configured to:

determine the Q reference signals based on the configuration information of the Q reference signals; and
determine the model coefficient of the equivalent power amplifier based on the receiving signal, the Q reference signals, and the model parameters of the equivalent power amplifiers.

Optionally, the configuration information of the Q reference signals includes one or more of the following: type information of the Q reference signals, sequence information of the Q reference signals, time-frequency resource information of the Q reference signals, or antenna port information for sending the Q reference signals, where the sequence information of the Q reference signals is different, and the time-frequency resource information is in a one-to-one correspondence with the antenna port information.

Optionally, the model parameter includes at least one of a nonlinear order, a memory depth, a cross-term length, or a model type.

Optionally, the first configuration information further indicates bandwidth information of the Q reference signals.

Optionally, the Q digital channels are connected to respective corresponding power amplifiers.

An embodiment of this application provides a communication apparatus. FIG. 22 is a diagram of a structure of a communication apparatus 2200 according to an embodiment of this application. The apparatus 2200 may be used or deployed in the network device in the method embodiments in FIG. 9 and FIG. 11. The communication apparatus 2200 includes a transceiver unit 2210.

The transceiver unit 2210 is configured to send first configuration information to Q terminal devices, where the first configuration information indicates configuration information of Q reference signals, and Q is an integer greater than 1.

The transceiver unit 2210 is further configured to send second configuration information to the Q terminal devices, where the second configuration information indicates model parameters of equivalent power amplifiers connected to Q digital channels of the apparatus 2200.

The transceiver unit 2210 is further configured to send the Q reference signals to the Q terminal devices through P physical antennas, where the power amplifiers are connected to the physical antennas in a one-to-one correspondence, and P is an integer greater than or equal to Q.

The transceiver unit 2210 is further configured to receive model coefficients of Q equivalent power amplifiers sent by the Q terminal devices, where the equivalent power amplifiers are equivalent power amplifiers of power amplifiers connected to the digital channels corresponding to receiving signals of the terminal devices, and the receiving signals are the Q reference signals received by the terminal devices.

Optionally, the configuration information of the Q reference signals includes one or more of the following: type information of the Q reference signals, sequence information of the Q reference signals, time-frequency resource information of the Q reference signals, or antenna port information for sending the Q reference signals, where the sequence information of the Q reference signals is different, and the time-frequency resource information is in a one-to-one correspondence with the antenna port information.

Optionally, the model parameter includes at least one of a nonlinear order, a memory depth, a cross-term length, or a model type.

Optionally, the first configuration information further indicates bandwidth information of the Q reference signals.

Optionally, the apparatus 2200 further includes a processing unit 2220.

The processing unit 2220 is configured to determine, based on the model coefficients of the Q equivalent power amplifiers and the Q reference signals, digital predistortion coefficients respectively corresponding to the Q digital channels.

Optionally, the processing unit 2220 is specifically configured to:

determine Q receiving signals of the Q terminal devices based on the model coefficients of the Q equivalent power amplifiers, the Q reference signals, and the model parameters of the equivalent power amplifiers, where the receiving signals are in a one-to-one correspondence with the terminal devices; and

determine, based on the Q receiving signals and a $q^{th}$ reference signal in the Q reference signals, a digital predistortion coefficient corresponding to a $q^{th}$ digital channel in the Q digital channels, where the $q^{th}$ digital channel is a digital channel corresponding to the $q^{th}$ reference signal, and $1 \leq q \leq Q$.

Optionally, the Q digital channels are connected to respective corresponding power amplifiers.

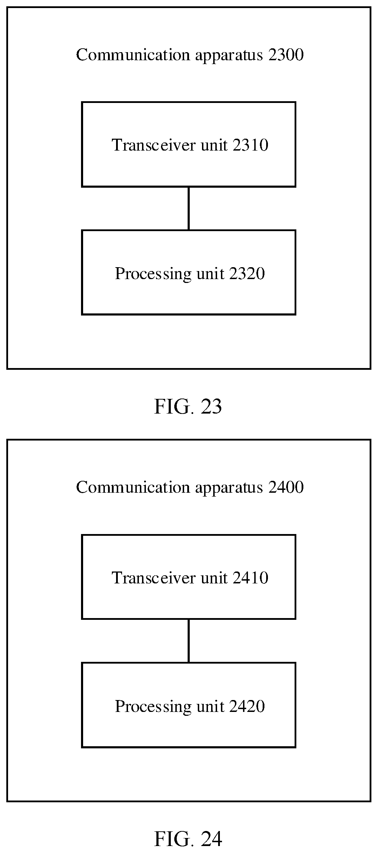

An embodiment of this application provides a communication apparatus. FIG. 23 is a diagram of a structure of a communication apparatus 2300 according to an embodiment of this application. The apparatus 2300 may be used or deployed in the terminal device in the method embodiments in FIG. 14 and FIG. 17. The communication apparatus 2300 includes a transceiver unit 2310 and a processing unit 2320.

The transceiver unit 2310 is configured to receive first configuration information sent by a network device, where the first configuration information indicates configuration information of a reference signal.

The transceiver unit 2310 is further configured to receive second configuration information sent by the network device, where the second configuration information indicates a model parameter of an equivalent power amplifier connected to a digital channel of the network device.

The transceiver unit 2310 is further configured to receive the reference signal sent by the network device, to obtain a receiving signal.

The processing unit 2320 is configured to determine a model coefficient of an equivalent power amplifier based on the receiving signal, the configuration information of the reference signal, and the model parameter of the equivalent power amplifier, where the equivalent power amplifier is an equivalent power amplifier of power amplifiers connected to the digital channel.

The transceiver unit 2310 is further configured to send the model coefficient of the equivalent power amplifier to the network device.

Optionally, the processing unit 2320 is specifically configured to:

determine the reference signal based on the configuration information of the reference signal; and

determine the model coefficient of the equivalent power amplifier based on the receiving signal, the reference signal, and the model parameter of the equivalent power amplifier.

Optionally, the configuration information of the reference signal includes one or more of the following: type information of the reference signal, sequence information of the reference signal, time-frequency resource information of the reference signal, or antenna port information for sending the reference signal, where the time-frequency resource information corresponds to the antenna port information.

Optionally, the model parameter includes at least one of a nonlinear order, a memory depth, a cross-term length, or a model type.

Optionally, the first configuration information further indicates bandwidth information of the reference signal.

Optionally, each of the power amplifiers is connected to one digital channel of the network device.

An embodiment of this application provides a communication apparatus. FIG. 24 is a diagram of a structure of a communication apparatus 2400 according to an embodiment of this application. The apparatus 2400 may be used or deployed in the network device in the method embodiments in FIG. 14 and FIG. 17. The communication apparatus 2400 includes a transceiver unit 2410.

The transceiver unit 2410 is configured to send first configuration information to a terminal device, where the first configuration information indicates configuration information of a reference signal.

The transceiver unit 2410 is further configured to send second configuration information to the terminal device, where the second configuration information indicates a model parameter of an equivalent power amplifier connected to a digital channel of the apparatus 2400.

A transceiver unit 2410 is further configured to send the reference signal to the terminal device through at least one physical antenna corresponding to the digital channel, where the power amplifier is connected to the physical antenna in a one-to-one correspondence.

The transceiver unit 2410 is further configured to receive a model coefficient of an equivalent power amplifier sent by the terminal device, where the equivalent power amplifier is an equivalent power amplifier of power amplifiers connected to the digital channel, and the receiving signal is the reference signal received by the terminal device.

Optionally, the configuration information of the reference signal includes one or more of the following: type information of the reference signal, sequence information of the reference signal, time-frequency resource information of the reference signal, or antenna port information for sending the reference signal, where the time-frequency resource information corresponds to the antenna port information.

Optionally, the model parameter includes at least one of a nonlinear order, a memory depth, a cross-term length, or a model type.

Optionally, the first configuration information further indicates bandwidth information of the reference signal.

Optionally, the apparatus 2400 further includes a processing unit 2420. The processing unit 2420 is configured to determine, based on the model coefficient of the equivalent power amplifier and the reference signal, a digital predistortion coefficient corresponding to the digital channel.

Optionally, the processing unit 2420 is specifically configured to:

determine the receiving signal of the terminal device based on the model coefficient of the equivalent power amplifier, the reference signal, and the model parameter of the equivalent power amplifier; and
determine, based on the receiving signal and the reference signal, the digital predistortion coefficient corresponding to the digital channel.

Optionally, each of the power amplifiers is connected to one digital channel of the apparatus 2400.

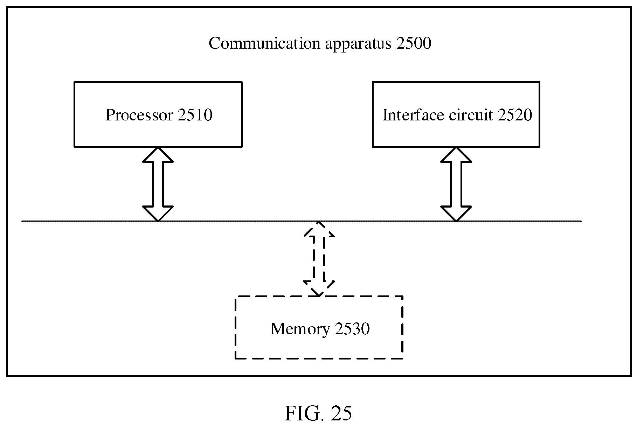

An embodiment of this application provides a communication apparatus 2500. FIG. 25 is a block diagram of a communication apparatus 2500 according to an embodiment of this application.

The communication apparatus 2500 includes a processor 2510 and an interface circuit 2520. The processor 2510 and the interface circuit 2520 are coupled to each other. It may be understood that the interface circuit 2520 may be a transceiver or an input/output interface. Optionally, the communication apparatus 2500 may further include a memory 2530, configured to: store instructions executed by the processor 2510, store input data needed by the processor 2510 to run instructions, or store data generated after the processor 2510 runs instructions.

When the communication apparatus 2500 is used in the terminal device, the communication apparatus 2500 may implement functions of the terminal device in the foregoing method embodiments. When the communication apparatus 2500 is used in the network device, the communication apparatus 2500 may implement functions of the network device in the foregoing method embodiments.

The processor 2510 may be an integrated circuit chip and has a capability of processing a signal. In an implementation process, the steps in the foregoing method embodiments are implemented by using a hardware integrated logic circuit in the processor, or by using instructions in the form of software. The foregoing processor may be a general-purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or transistor logic device, or a discrete hardware component. It may implement or perform the methods, the steps, and logical block diagrams that are disclosed in embodiments of this application. The general-purpose processor may be a microprocessor, or the processor may be any conventional processor or the like. The steps in the methods disclosed with reference to embodiments of this application may be directly performed and completed by a hardware decoding processor, or may be performed and completed by using a combination of hardware in the decoding processor and a software module. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor.

An embodiment of this application further provides a communication system, including a terminal device in the information measurement method provided in embodiments of this application, another communication device communicating with the terminal device, a network device, and another communication device communicating with the network device.

An embodiment of this application further provides a computer-readable storage medium. The computer-readable storage medium stores a computer program used to implement the method in the foregoing method embodiments. When the computer program is run on a computer, the computer is enabled to implement the method in the foregoing method embodiments.

An embodiment of this application further provides a computer program product. The computer program product includes computer program code, and when the computer program code is run on a computer, the method in the foregoing method embodiment is performed.

An embodiment of this application further provides a chip, including a processor. The processor is connected to a memory. The memory is configured to store a computer program. The processor is configured to execute the computer program stored in the memory, so that the chip performs the method in the foregoing method embodiments.

It should be understood that, in embodiments of this application, for a technical feature, "first", "second", "third", and the like are used to distinguish between technical features in the technical feature, and there is no time or magnitude order between the technical features described by "first", "second", and "third". In embodiments of this application, "at least one" may alternatively be described as one or more, and "more" may be two, three, four, or more. This is not limited in this application.

In addition, the term "and/or" in this application describes only an association relationship for describing associated objects and represents that three relationships may exist. For example, A and/or B may represent the following three cases: Only A exists, both A and B exist, and only B exists. In addition, the character "/" in this specification usually represents an "or" relationship between associated objects. In this application, the term "at least one" may represent "one" or "two or more". For example, at least one of A, B, and C may represent the following seven cases: Only A exists, only B exists, only C exists, both A and B exist, both A and C exist, both C and B exist, and A, B, C all exist.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that this implementation goes beyond the scope of this application.

A person skilled in the art may clearly learn that, for the purpose of convenient and brief description, for a specific working process of the foregoing system, apparatus, and unit, refer to a corresponding process in the foregoing method embodiments. Details are not described herein again.

In several embodiments provided in this application, it should be understood that the disclosed system, apparatus, and method may be implemented in other manners. For example, the described apparatus embodiments are merely an example. For example, the unit division is merely logical function division and may be other division during actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the current technology, or some of the technical solutions may be implemented in the form of a software product. The computer software product is stored in a storage medium, and includes a plurality of instructions to cause a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An information measurement method, comprising:

   receiving, by a terminal device, first configuration information sent by a network device, wherein the first configuration information indicates configuration information of Q reference signals, and Q is an integer greater than 1;
   receiving, by the terminal device, second configuration information sent by the network device, wherein the second configuration information indicates model parameters of equivalent power amplifiers connected to Q digital channels of the network device;
   receiving, by the terminal device, the Q reference signals sent by the network device, to obtain a receiving signal;
   determining, by the terminal device, a model coefficient of an equivalent power amplifier based on the receiving signal, the configuration information of the Q reference signals, and the model parameters of the equivalent power amplifiers, wherein the equivalent power amplifier is an equivalent power amplifier of power amplifiers connected to the digital channel corresponding to the receiving signal; and
   sending, by the terminal device, the model coefficient of the equivalent power amplifier to the network device.

2. The method according to claim 1, wherein the determining, by the terminal device, a model coefficient of an equivalent power amplifier based on the receiving signal, the configuration information of the Q reference signals, and the model parameters of the equivalent power amplifiers comprises:

   determining, by the terminal device, the Q reference signals based on the configuration information of the Q reference signals; and
   determining, by the terminal device, the model coefficient of the equivalent power amplifier based on the receiving signal, the Q reference signals, and the model parameters of the equivalent power amplifiers.

3. The method according to claim 1 or 2, wherein
   the configuration information of the Q reference signals comprises one or more of the following: type information of the Q reference signals, sequence information of the Q reference signals, time-frequency resource information of the Q reference signals, or antenna port information for sending the Q reference signals, wherein the sequence information of the Q reference signals is different, and the time-frequency resource information is in a one-to-one correspondence with the antenna port information.

4. The method according to any one of claims 1 to 3, wherein
   the model parameter comprises at least one of a nonlinear order, a memory depth, a cross-term length, or a model type.

5. The method according to any one of claims 1 to 4, wherein
   the first configuration information further indicates bandwidth information of the Q reference signals.

6. The method according to any one of claims 1 to 5, wherein
   the Q digital channels are connected to respective corresponding power amplifiers.

7. An information measurement method, comprising:

   sending, by a network device, first configuration information to Q terminal devices, wherein the first configuration information indicates configuration information of Q reference signals, and Q is an integer greater than 1;
   sending, by the network device, second configuration information to the Q terminal devices, wherein the second configuration information indicates model parameters of equivalent power amplifiers connected to Q digital channels of the network device;
   sending, by the network device, the Q reference signals to the Q terminal devices through P physical antennas, wherein power amplifiers are connected to the physical antennas in a one-to-one correspondence, and P is an integer greater than or equal to Q; and

receiving, by the network device, model coefficients of Q equivalent power amplifiers sent by the Q terminal devices, wherein the equivalent power amplifiers are equivalent power amplifiers of power amplifiers connected to the digital channels corresponding to receiving signals of the terminal devices, and the receiving signals are the Q reference signals received by the terminal devices.

8. The method according to claim 7, wherein

the configuration information of the Q reference signals comprises one or more of the following: type information of the Q reference signals, sequence information of the Q reference signals, time-frequency resource information of the Q reference signals, or antenna port information for sending the Q reference signals, wherein the sequence information of the Q reference signals is different, and the time-frequency resource information is in a one-to-one correspondence with the antenna port information.

9. The method according to claim 7 or 8, wherein

the model parameter comprises at least one of a nonlinear order, a memory depth, a cross-term length, or a model type.

10. The method according to any one of claims 7 to 9, wherein

the first configuration information further indicates bandwidth information of the Q reference signals.

11. The method according to any one of claims 7 to 10, wherein the method further comprises:

determining, by the network device based on the model coefficients of the Q equivalent power amplifiers and the Q reference signals, digital predistortion coefficients respectively corresponding to the Q digital channels.

12. The method according to claim 11, wherein the determining, by the network device based on the model coefficients of the Q equivalent power amplifiers and the Q reference signals, digital predistortion coefficients respectively corresponding to the Q digital channels comprises:

determining, by the network device, Q receiving signals of the Q terminal devices based on the model coefficients of the Q equivalent power amplifiers, the Q reference signals, and the model parameters of the equivalent power amplifiers, wherein the receiving signals are in a one-to-one correspondence with the terminal devices; and

determining, by the network device based on the Q receiving signals and a $q^{th}$ reference signal in the Q reference signals, a digital predistortion coefficient corresponding to a $q^{th}$ digital channel in the Q digital channels, wherein the $q^{th}$ digital channel is a digital channel corresponding to the $q^{th}$ reference signal, and $1 \leq q \leq Q$.

13. The method according to any one of claims 7 to 12, wherein

the Q digital channels are connected to respective corresponding power amplifiers.

14. An information measurement method, comprising:

receiving, by a terminal device, first configuration information sent by a network device, wherein the first configuration information indicates configuration information of a reference signal;

receiving, by the terminal device, second configuration information sent by the network device, wherein the second configuration information indicates a model parameter of an equivalent power amplifier connected to a digital channel of the network device;

receiving, by the terminal device, the reference signal sent by the network device, to obtain a receiving signal;

determining, by the terminal device, a model coefficient of an equivalent power amplifier based on the receiving signal, the configuration information of the reference signal, and the model parameter of the equivalent power amplifier, wherein the equivalent power amplifier is an equivalent power amplifier of power amplifiers connected to the digital channel; and

sending, by the terminal device, the model coefficient of the equivalent power amplifier to the network device.

15. The method according to claim 14, wherein the determining, by the terminal device, a model coefficient of an equivalent power amplifier based on the receiving signal, the configuration information of the reference signal, and the model parameter of the equivalent power amplifier comprises:

determining, by the terminal device, the reference signal based on the configuration information of the reference signal; and

determining, by the terminal device, the model coefficient of the equivalent power amplifier based on the receiving signal, the reference signal, and the model parameter of the equivalent power amplifier.

16. The method according to claim 14 or 15, wherein
the configuration information of the reference signal comprises one or more of the following: type information of the reference signal, sequence information of the reference signal, time-frequency resource information of the reference signal, or antenna port information for sending the reference signal, wherein the time-frequency resource information corresponds to the antenna port information.

17. The method according to any one of claims 14 to 16, wherein
the model parameter comprises at least one of a nonlinear order, a memory depth, a cross-term length, or a model type.

18. The method according to any one of claims 14 to 17, wherein
the first configuration information further indicates bandwidth information of the reference signal.

19. The method according to any one of claims 14 to 18, wherein
each of the power amplifiers is connected to one digital channel of the network device.

20. An information measurement method, comprising:

sending, by a network device, first configuration information to a terminal device, wherein the first configuration information indicates configuration information of a reference signal;
sending, by the network device, second configuration information to the terminal device, wherein the second configuration information indicates a model parameter of an equivalent power amplifier connected to a digital channel of the network device;
sending, by the network device, the reference signal to the terminal device through at least one physical antenna corresponding to the digital channel, wherein a power amplifier is connected to the physical antenna in a one-to-one correspondence; and
receiving, by the network device, a model coefficient of an equivalent power amplifier sent by the terminal device, wherein the equivalent power amplifier is an equivalent power amplifier of power amplifiers connected to the digital channel, and a receiving signal is the reference signal received by the terminal device.

21. The method according to claim 20, wherein
the configuration information of the reference signal comprises one or more of the following: type information of the reference signal, sequence information of the reference signal, time-frequency resource information of the reference signal, or antenna port information for sending the reference signal, wherein the time-frequency resource information corresponds to the antenna port information.

22. The method according to claim 20 or 21, wherein
the model parameter comprises at least one of a nonlinear order, a memory depth, a cross-term length, or a model type.

23. The method according to any one of claims 20 to 22, wherein
the first configuration information further indicates bandwidth information of the reference signal.

24. The method according to any one of claims 20 to 23, wherein the method further comprises:
determining, by the network device based on the model coefficient of the equivalent power amplifier and the reference signal, a digital predistortion coefficient corresponding to the digital channel.

25. The method according to claim 24, wherein the determining, by the network device based on the model coefficient of the equivalent power amplifier and the reference signal, a digital predistortion coefficient corresponding to the digital channel comprises:

determining, by the network device, the receiving signal of the terminal device based on the model coefficient of the equivalent power amplifier, the reference signal, and the model parameter of the equivalent power amplifier; and

determining, by the network device based on the receiving signal and the reference signal, the digital predistortion coefficient corresponding to the digital channel.

26. The method according to any one of claims 20 to 25, wherein
each of the power amplifiers is connected to one digital channel of the network device.

27. A communication apparatus, comprising a unit configured to perform the method according to any one of claims 1 to 26.

28. A communication apparatus, comprising a processor and an interface circuit, wherein the interface circuit is configured to receive a signal from another communication apparatus and transmit the signal to the processor or send a signal from the processor to another communication apparatus, and the processor is configured to implement the method according to any one of claims 1 to 26 by using a logic circuit or executing code instructions.

29. A computer-readable storage medium, wherein

the computer-readable medium stores computer code or instructions; and
when the computer code or instructions are run by a processor, the method according to any one of claims 1 to 26 is performed.

30. A computer program product, comprising computer code or instructions, wherein when the computer code or instructions are executed, the method according to any one of claims 1 to 26 is implemented.

FIG. 1

Input → Digital predistortion → PA → Output

+ = 

FIG. 2

PA 1: DPD → DAC → PA → Wireless interface; Model extraction

⋮

PA N: DPD → DAC → PA → Wireless interface; Model extraction

FIG. 3

FIG. 4

Local oscillator    Variable gain amplifier    Phase shifter    Combiner

FIG. 5

EP 4 572 246 A1

FIG. 6

EP 4 572 246 A1

FIG. 7

EP 4 572 246 A1

FIG. 8

900

```
┌─────────────┐                                    ┌─────────────┐
│  Network    │                                    │  Terminal   │
│  device     │                                    │  device     │
└──────┬──────┘                                    └──────┬──────┘
```

910: First configuration information, indicating configuration
information of Q reference signals

920: Receive the first configuration
information

930: Second configuration information, indicating model
parameters of equivalent power amplifiers connected to Q
digital channels of the network device

940: Receive the second configuration
information

950: Q reference signals

960: Receive the Q reference signals

970: Determine, based on a receiving signal,
the configuration information of the Q
reference signals, and the model parameters
of the equivalent power amplifiers, a model
coefficient of an equivalent power amplifier
of power amplifiers connected to a
corresponding digital channel

980: Model coefficient of the equivalent power amplifier

990: Receive the model coefficient of the equivalent
power amplifier sent by the terminal device

FIG. 9

FIG. 10

EP 4 572 246 A1

| Network device | | Terminal device |
|---|---|---|

1110: First configuration information, indicating configuration information of Q reference signals →

1120: Second configuration information, indicating model parameters of equivalent power amplifiers connected to Q digital channels of the network device →

1130: Q reference signals →

1140: Determine, based on a receiving signal, the configuration information of the Q reference signals, and the model parameters of the equivalent power amplifiers, a model coefficient of an equivalent PA of PAs connected to a corresponding digital channel

1150: Model coefficient of the equivalent PA ←

1160: Receive the model coefficient of the equivalent PA sent by the terminal device

1170: Determine a DPD coefficient corresponding to the digital channel

FIG. 11

EP 4 572 246 A1

Multiple REs

One slot

(a)

Multiple REs

One slot

(b)

Demodulation reference signal

Reference signal

FIG. 12

| | | | RS 1 | | | RS 1 | | | RS 1 | | |
|---|---|---|---|---|---|---|---|---|---|---|---|

Reference signal

| | | | RS 2 | | | RS 2 | | | RS 2 | | |
|---|---|---|---|---|---|---|---|---|---|---|---|

$\vdots$

| | | | RS Q | | | RS Q | | | RS Q | | |
|---|---|---|---|---|---|---|---|---|---|---|---|

FIG. 13

1400

```
┌──────────┐                                                      ┌──────────┐
│ Network  │                                                      │ Terminal │
│ device   │                                                      │ device   │
└──────────┘                                                      └──────────┘
```

1410: First configuration information, indicating configuration information of a reference signal

1420: Receive the first configuration information

1430: Second configuration information, indicating a model parameter of an equivalent power amplifier connected to a digital channel of the network device

1440: Receive the second configuration information

1450: Reference signal

1460: Receive the reference signal

1470: Determine, based on a receiving signal, the configuration information of the reference signal, and the model parameter of the equivalent power amplifier, a model coefficient of an equivalent power amplifier of power amplifiers connected to the digital channel

1480: Model coefficient of the equivalent power amplifier

1490: Receive the model coefficient of the equivalent power amplifier sent by the terminal device

FIG. 14

FIG. 15

Beam area #1

Beam area #2

Beam area #3

Network
device

Terminal devices
for feedback

FIG. 16

```
┌─────────┐                                              ┌─────────┐
│ Network │                                              │ Terminal│
│ device  │                                              │ device  │
└─────────┘                                              └─────────┘
     │                                                        │
     │  1710: First configuration information, indicating     │
     │  configuration information of Q reference signals      │
     │ ──────────────────────────────────────────────────▶   │
     │                                                        │
     │  1720: Second configuration information, indicating model │
     │  parameters of equivalent power amplifiers connected to Q │
     │      digital channels of the network device           │
     │ ──────────────────────────────────────────────────▶   │
     │                                                        │
     │            1730: Q reference signals                   │
     │ ──────────────────────────────────────────────────▶   │
```

1740: Determine, based on Q receiving signals, the configuration information of the Q reference signals, and the model parameters of the equivalent power amplifiers connected to the Q digital channels, model coefficients of the equivalent PAs connected to the Q digital channels

```
     │  1750: Model coefficients of the equivalent PAs        │
     │        connected to the Q digital channels             │
     │ ◀──────────────────────────────────────────────────   │
```

1760: Receive the model coefficient of the equivalent PA sent by the terminal device

1770: Determine DPD coefficients corresponding to the Q digital channels

FIG. 17

FIG. 18

Digital channel 1     Digital channel 2

| | | | RS 1 | | | | RS 2 | | | | RS 1 | | | | RS 2 | | | |

Trigger measurement

Report

FIG. 19

u(n) → DPD → PA → r(n)

FIG. 20

Communication apparatus 2100

Transceiver unit 2110

Processing unit 2120

FIG. 21

Communication apparatus 2200

Transceiver unit 2210

Processing unit 2220

FIG. 22

Communication apparatus 2300

Transceiver unit 2310

Processing unit 2320

FIG. 23

Communication apparatus 2400

Transceiver unit 2410

Processing unit 2420

FIG. 24

Communication apparatus 2500

Processor 2510

Interface circuit 2520

Memory 2530

FIG. 25

# EP 4 572 246 A1

## INTERNATIONAL SEARCH REPORT

International application No.

**PCT/CN2023/105346**

### A. CLASSIFICATION OF SUBJECT MATTER

H04L25/49(2006.01)i; H04W24/02(2009.01)i

According to International Patent Classification (IPC) or to both national classification and IPC

### B. FIELDS SEARCHED

Minimum documentation searched (classification system followed by classification symbols)

IPC: H04L H04W

Documentation searched other than minimum documentation to the extent that such documents are included in the fields searched

Electronic data base consulted during the international search (name of data base and, where practicable, search terms used)

WPABS, ENTXTC, CNTXT, ENTXT, CNKI: 功率放大器, 预失真, 配置, 参考信号, 模型, 参数, 系数, 等效, 训练, 数字通道, 反馈; Power amplifier, pre-distortion, configuration, reference signal, model, parameters, coefficients, equivalent, training, digital channel, feedback

### C. DOCUMENTS CONSIDERED TO BE RELEVANT

| Category* | Citation of document, with indication, where appropriate, of the relevant passages | Relevant to claim No. |
|---|---|---|
| X | CN 113809992 A (NOKIA TECHNOLOGIES OY) 17 December 2021 (2021-12-17) description, paragraphs 0033-0104 | 14-30 |
| Y | CN 113809992 A (NOKIA TECHNOLOGIES OY) 17 December 2021 (2021-12-17) description, paragraphs 0033-0104 | 1-13 |
| Y | CN 111988250 A (TSINGHUA UNIVERSITY) 24 November 2020 (2020-11-24) description, paragraphs 0038-0122 | 1-13 |
| A | CN 101977081 A (SUNWAVE COMMUNICATIONS CO., LTD.) 16 February 2011 (2011-02-16) entire document | 1-30 |
| A | CN 111490737 A (CHINA MOBILE COMMUNICATIONS CORPORATION RESEARCH INSTITUTE et al.) 04 August 2020 (2020-08-04) entire document | 1-30 |
| A | US 2015043678 A1 (HAMMI, Oualid) 12 February 2015 (2015-02-12) entire document | 1-30 |

☑ Further documents are listed in the continuation of Box C. ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **22 September 2023** | **28 September 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

54

**INTERNATIONAL SEARCH REPORT**

| International application No. |
| --- |
| **PCT/CN2023/105346** |

**C.    DOCUMENTS CONSIDERED TO BE RELEVANT**

| Category* | Citation of document, with indication, where appropriate, of the relevant passages | Relevant to claim No. |
| --- | --- | --- |
| A | US 8666336 B1 (XILINX, INC.) 04 March 2014 (2014-03-04)<br>     entire document | 1-30 |

Form PCT/ISA/210 (second sheet) (July 2022)

**INTERNATIONAL SEARCH REPORT**
Information on patent family members

International application No.

**PCT/CN2023/105346**

| Patent document cited in search report | | | Publication date (day/month/year) | Patent family member(s) | | | Publication date (day/month/year) |
|---|---|---|---|---|---|---|---|
| CN | 113809992 | A | 17 December 2021 | EP | 3923471 | A1 | 15 December 2021 |
| | | | | US | 2021391832 | A1 | 16 December 2021 |
| | | | | US | 11431300 | B2 | 30 August 2022 |
| CN | 111988250 | A | 24 November 2020 | None | | | |
| CN | 101977081 | A | 16 February 2011 | None | | | |
| CN | 111490737 | A | 04 August 2020 | None | | | |
| US | 2015043678 | A1 | 12 February 2015 | US | 9214969 | B2 | 15 December 2015 |
| US | 8666336 | B1 | 04 March 2014 | None | | | |

Form PCT/ISA/210 (patent family annex) (July 2022)

**EP 4 572 246 A1**

**REFERENCES CITED IN THE DESCRIPTION**

**Patent documents cited in the description**

- CN 202211053928